# EUROPEAN PATENT APPLICATION

(11) **EP 4 756 436 A1**
(43) Date of publication of application: **10.06.2026**
(21) Application number: 23947407.5
(22) Date of filing: 13.12.2023
(51) Int. Cl.: G01R 19/00, G01R 33/06, G01R 33/09, G01R 33/07

(54) **MAGNETIC CURRENT SENSOR**

(30) Priority: 01.08.2023 CN 202310960553
(71) Applicant: MultiDimension Technology Co., Ltd., Jiangsu 215634 (CN)
(72) Inventor: LIU, Mingfeng, Jiangsu 215634 (CN); SHI, Ran, Jiangsu 215634 (CN); XUE, Songsheng, Jiangsu 215634 (CN)
(74) Representative: HGF
(86) International application number: PCT/CN2023/138295
(87) International publication number: WO 2025/025470

(57) **Abstract**

A magnetic current sensor, comprising: a wire under current measurement (10), a magnetism gathering ring (20), a differential magnetic field generation module (30), and a differential detection module (40), wherein the differential magnetic field generation module (30) comprises a magnetic field conversion unit and at least two magnetic induction units; the magnetism gathering ring (20) gathers and amplifies an annular induced magnetic field generated by said wire (10), and then the annular induced magnetic field penetrates through the opening of the magnetism gathering ring (20); the magnetic field conversion unit located at the opening position of the magnetism gathering ring (20) forms a magnetic flux path under the magnetic flux guiding effect of a soft magnetic metal material having high permeability, the magnetic flux path is used for converting a magnetic field direction, and a magnetic field component parallel to a plane where the magnetic induction units are located is generated at the air gap of the magnetic flux path, so that a differential voltage signal is generated and detection is carried out by means of the differential detection module (40). Therefore, differential detection with a combination of an annular iron core structure and a single-sensitivity direction magnetic induction unit can be achieved, single-chip integrated manufacturing can be achieved, the sensitivity consistency is good, the accuracy is high, the anti-interference capability is strong, and the application range is wide.

## Description

### Technical Field

The present application relates to the technical field of magnetic field measurement, and in particular, to a magnetic current sensor.

### Background of the Invention

Current sensors are a type of current detection devices that can convert, according to certain rules, and output detected information of a current to be detected into an electrical signal or information in other desired forms that meet certain standard requirements, so as to meet the requirements for information transmission, processing, storage, display, recording, and control. They are widely used in many fields including home appliances, smart grids, electric vehicles, and wind power generation. Currently, the most widely used current sensors are magnetic current sensors, which mainly include fluxgate current sensors, Hall current sensors, and magnetoresistive current sensors.

Currently, due to the consistent magnetic field direction of the annular iron core structure in existing magnetic current sensors, it is difficult to form a differential magnetic field. Annular iron cores are usually directly combined with fluxgates or Hall elements for measurement. However, for magnetoresistive devices, two sets of magnetoresistive devices with opposite sensitivity directions are usually used to form a push-pull bridge for magnetic field detection in the same direction, which can easily cause angle deviation and zero-point offset, thereby affecting the sensitivity consistency.

### Summary of the Invention

In view of this, the objective of embodiments of the present application is to provide a magnetic current sensor, wherein a magnetism gathering ring gathers and amplifies an annular induced magnetic field generated by a wire under current measurement, and then the annular induced magnetic field penetrates through the opening of the magnetism gathering ring; a magnetic field conversion unit located at the opening position of the magnetism gathering ring forms a magnetic flux path under the magnetic flux guiding effect of a soft magnetic metal material having high permeability, the magnetic flux path is used for converting a magnetic field direction, and a magnetic field component parallel to a plane where the magnetic induction units are located is generated at the air gap of the magnetic flux path, so that a differential voltage signal is generated and an output signal is formed by means of a differential detection module. Differential detection with a combination of an annular iron core structure and a single-sensitivity direction magnetic induction unit can be achieved, single-chip integrated manufacturing can be achieved, the sensitivity consistency is good, the accuracy is high, the anti-interference capability is strong, and the application range is wide, thereby solving the above technical problems.

In a first aspect, embodiments of the present application provide a magnetic current sensor, the sensor comprising: a wire under current measurement, a magnetism gathering ring, a differential magnetic field generation module, and a differential detection module; the magnetism gathering ring comprises a magnetic ring structure with an opening; the wire under current measurement passes through the hollow region of the magnetic ring structure; the differential magnetic field generation module is located at the opening of the magnetic ring structure; the differential detection module is electrically connected to the differential magnetic field generation module; the differential magnetic field generation module comprises: a magnetic field conversion unit and at least two magnetic induction units; the magnetic field conversion unit is connected to the open magnetic circuit to form a closed magnetic flux path; the magnetic induction unit is located at an air gap of the magnetic field conversion unit, and the sensitivity direction of the magnetic induction unit is perpendicular to the vertical projection direction of the air gap; wherein the magnetism gathering ring is used to gather and amplify the induced magnetic field generated by the wire under current measurement; the magnetic field conversion unit is used to guide the gathered and amplified induced magnetic field to the magnetic flux path and generate a differential magnetic field component in the air gap of the magnetic flux path; the magnetic induction unit is used to generate a differential voltage signal based on the differential magnetic field component; and the differential detection module is used to process the differential voltage signal and output an electrical signal to be measured.

In the above-described implementation process, the magnetism gathering ring gathers and amplifies an annular induced magnetic field generated by the wire under current measurement, and then the annular induced magnetic field penetrates through the opening of the magnetism gathering ring; the magnetic field conversion unit located at the opening position of the magnetism gathering ring forms a magnetic flux path under the magnetic flux guiding effect of a soft magnetic metal material having high permeability, the magnetic flux path is used for converting a magnetic field direction, and a magnetic field component parallel to a plane where the magnetic induction units are located is generated at the air gap of the magnetic flux path, so that a differential voltage signal is generated and an output signal is formed by means of the differential detection module. Differential detection with a combination of an annular iron core structure and a single-sensitivity direction magnetic induction unit can be achieved, single-chip integrated manufacturing can be achieved, the sensitivity consistency is good, the accuracy is high, the anti-interference capability is strong, and the application range is wide.

Optionally, the magnetism gathering ring comprises a single magnetic ring structure with an opening; the magnetic field conversion unit comprises: a magnetic field input region, a magnetic field output region, multiple magnetic flux direction conversion regions, and multiple magnetic flux path connection regions; the multiple magnetic flux path connection regions comprise: at least two air gaps located at different positions; the at least two magnetic induction units are correspondingly disposed at the positions of the at least two air gaps; the magnetic field input region is connected to one end of the opening; the magnetic field output region is connected to the other end of the opening; the magnetic flux direction conversion region is located in a corner region of the magnetic field conversion unit, and the magnetic flux path connection region connects two adjacent corner regions and forms a closed magnetic flux path with the magnetic field input region and the magnetic field output region.

In the above-described implementation process, the annular iron core with a single magnetic ring structure is used to gather and amplify the annular induced magnetic field of the wire under current measurement, the magnetic flux guiding effect of the soft magnetic metal material on the substrate embedded into the opening in the magnetic field conversion unit is utilized to form two parallel magnetic flux paths, and magnetic field components with opposite directions are generated in air gaps at different locations to form a differential magnetic field, thereby enabling the formation of a push-pull bridge structure and realizing differential detection by a combination of the annular iron core structure with a single-sensitivity direction magnetic induction unit. Meanwhile, adjusting the plane where the substrate is located can be applied to magnetic induction units with sensitivity directions perpendicular to and parallel to their own planes, which avoids the problems of angle deviation and zero-point offset caused by using different sensitivity directions in the prior art, and achieves good sensitivity consistency, high measurement accuracy, and good stability.

Optionally, the magnetic induction unit further comprises: a magnetic shielding reference magnetic induction unit and an external magnetic field reference magnetic induction unit; the magnetic shielding reference magnetic induction unit is located within the vertical projection range of the magnetic field conversion unit; the external magnetic field reference magnetic induction unit is located outside the vertical projection range of the magnetic field conversion unit; the at least two magnetic induction units are used to form magnetoresistance of a push-pull half-bridge or push-pull full-bridge circuit to sense the induced magnetic field to generate a differential voltage signal; or the at least two magnetic induction units are used to form magnetoresistance of a differential half-bridge or differential full-bridge circuit with the external magnetic field reference magnetic induction unit to sense the induced magnetic field to generate a differential voltage signal; or the at least one magnetic induction unit and the magnetic shielding reference magnetic induction unit are used to form magnetoresistance of a differential half-bridge or differential full-bridge circuit to sense the induced magnetic field to generate a differential voltage signal.

In the above-described implementation process, by using a single magnetic ring structure to form an induced magnetic field, and introducing a magnetic shielding reference magnetic induction unit and an external magnetic field reference magnetic induction unit, a differential half-bridge or differential full-bridge structure is formed, which realizes the expansion of the application range and adaptive adjustments of the accuracy, reduces the process cost, and achieves good stability and high sensitivity consistency.

Optionally, the magnetism gathering ring comprises: at least two magnetic ring structures with openings; the at least two magnetic ring structures are placed in parallel along the direction of the wire under current measurement; the magnetic field conversion unit comprises: at least two magnetic field input regions, at least two magnetic field output regions, multiple magnetic flux direction conversion regions, and multiple magnetic flux path connection regions; the multiple magnetic flux path connection regions comprise: at least two air gaps located at different positions; the at least two magnetic induction units are correspondingly disposed at the positions of the at least two air gaps; the magnetic field input region is connected to one end of the opening; the magnetic field output region is connected to the other end of the opening; the magnetic flux direction conversion region is located in a corner region of the magnetic field conversion unit, and the magnetic flux path connection region connects two adjacent corner regions and forms a closed magnetic flux path with the magnetic field input region and the magnetic field output region; wherein the at least two magnetic induction units are used to form magnetoresistance of a push-pull half-bridge or push-pull full-bridge circuit to sense the induced magnetic field to generate a differential voltage signal.

In the above-described implementation process, a magnetism gathering ring with multiple magnetic ring structures placed in parallel is used to form an integrated structure with an auxiliary support housing, which gathers and amplifies the annular induced magnetic field of the wire under current measurement, the magnetic flux guiding effect of the soft magnetic metal material on the substrate embedded into the opening in the magnetic field conversion unit is utilized to form two magnetic flux paths that are merged and then separated, and magnetic field components with opposite directions are generated in air gaps at different locations to form a differential magnetic field, thereby enabling the formation of a push-pull bridge structure and realizing differential detection by a combination of the annular iron core structure with a single-sensitivity direction magnetic induction unit. The placement of multiple magnetic ring structure in parallel improves the flexibility of the measurement range, and the single-sensitivity direction magnetic induction unit avoids the problems of angle deviation and zero-point offset caused by using different sensitivity directions in the prior art, and achieves good sensitivity consistency, high measurement accuracy, and good stability.

Optionally, the magnetic field conversion unit further comprises: a magnetic flux-shielding soft magnetic path; the magnetic flux-shielding soft magnetic path connects two magnetic flux path connection regions that are arranged opposite each other along the vertical projection direction of the air gap in the multiple magnetic flux path connection regions; and the magnetic flux-shielding soft magnetic path is used to isolate external interference magnetic fields parallel to the sensitivity direction of the magnetic induction unit.

In the above-described implementation process, by introducing a magnetic flux-shielding soft magnetic path, the magnetic field input region and the magnetic field output region are separated, which shields the external interference magnetic field in the sensitivity direction at an air gap, thereby further enhancing the measurement accuracy and measurement range and improving the anti-interference capability.

Optionally, the magnetic field conversion unit further comprises: a magnetic flux-dividing magnetic flux path connection region; the magnetic flux-dividing magnetic flux path connection region is located between two magnetic flux direction conversion regions that are arranged opposite each other along the vertical projection direction of the air gap in the multiple magnetic flux direction conversion regions; and the magnetic flux-dividing magnetic flux path connection region is used to perform magnetic flux dividing on the differential magnetic field generated at the air gap.

In the above-described implementation process, by utilizing the induced magnetic field to generate magnetic field components with opposite directions in air gaps at different locations, a differential magnetic field is formed, thereby enabling the formation of a push-pull bridge structure. By introducing a magnetic flux-dividing magnetic flux path connection region, the magnitude of the magnetic field passing through an air gap can be regulated, thereby further controlling the measurement range and broadening the application scenarios.

Optionally, the at least two magnetic induction units are correspondingly disposed at the at least two air gaps on the side of the direction from the magnetic field input region to the magnetic field output region.

In the above-described implementation process, by setting at least two magnetic induction units on one side of a single magnetic flux path, a magnetic dividing effect can be produced to regulate the magnitude of the magnetic field at an air gap, further control the measurement range, and broaden the application scenarios.

Optionally, the magnetic field conversion unit and the at least two magnetic induction units are disposed on a circuit chip using a chip integration process, and the circuit chip is placed at the opening position of the magnetic ring structure.

In the above-described implementation process, the cost is reduced by using a single-chip integrated fabrication process to process the magnetic field conversion unit and the magnetic induction unit on the same chip.

Optionally, the magnetic flux direction conversion region and the magnetic flux path connection region share a regular rectangular structure of soft magnetic metal material.

In the above-described implementation process, the irregular soft magnetic metal material shared by the magnetic flux direction conversion region and the magnetic flux path connection region in the magnetic field conversion unit is correspondingly simplified into a regular shape such as a rectangle, thereby reducing the process difficulty and cost.

Optionally, the magnetic flux direction conversion region and the magnetic flux path connection region are formed by a rectangular structure of soft magnetic metal material with multiple reversals.

In the above-described implementation process, by using a rectangular structure of soft magnetic metal material with multiple reversals to form a magnetic field conversion unit, various forms of series and parallel magnetic circuits can be constructed, which are suitable for magnetic sensors with various functions, thereby expanding the application range and improving practicality.

Optionally, the differential detection module comprises: an open-loop signal conditioning circuit; the open-loop signal conditioning circuit is electrically connected to the magnetic induction unit; and the open-loop signal conditioning circuit performs conditioning and amplification, temperature compensation, and linearity correction on the differential voltage signal.

In the above-described implementation process, an open-loop signal conditioning circuit is used to perform conditioning and amplification, temperature compensation, and linearity correction, thereby achieving open-loop detection, improving detection accuracy, and obtaining good linearity.

Optionally, the differential detection module comprises: a closed-loop signal conditioning circuit and a magnetic field feedback coil; the closed-loop signal conditioning circuit is electrically connected to the magnetic induction unit; the closed-loop signal conditioning circuit, the magnetic field feedback coil, and the magnetic induction unit form a closed-loop magnetic field feedback structure; the closed-loop signal conditioning circuit is used to perform conditioning and amplification on the differential voltage signal; the magnetic field feedback coil is used to generate a feedback magnetic field based on the conditioned and amplified signal to achieve dynamic magnetic field balance, and the current in the magnetic field feedback coil is sampled to form the electrical signal to be measured.

In the above-described implementation process, a closed-loop signal conditioning circuit and a magnetic field feedback coil are used to perform differential detection, thereby realizing closed-loop negative feedback, improving accuracy, and obtaining good linearity.

Optionally, the magnetic field feedback coil is one of: located inside the magnetic induction unit, inside the circuit chip, penetrating through the magnetism gathering ring, or surrounding the magnetism gathering ring.

In the above-described implementation process, a closed-loop signal conditioning circuit and a magnetic field feedback coil are used to perform differential detection, thereby realizing closed-loop negative feedback. The magnetic field feedback coil can be located inside the magnetic induction unit, inside the circuit chip, or directly penetrate through the magnetism gathering ring, or surround the magnetism gathering ring, which improves the efficiency of negative feedback.

To make the above-mentioned objectives, features, and advantages of the present application more apparent and understandable, specific embodiments will be described in detail below in conjunction with the accompanying drawings.

### Brief Description of the Accompanying Drawings

In order to more clearly illustrate the technical solutions in the embodiments of the present application, the drawings required in the embodiments of the present application will be briefly introduced below. It should be understood that the drawings below illustrate merely some embodiments of the present application and should not be construed as limitations to the scope. Those skilled in the art may derive additional drawings based on these drawings without any creative work.
FIG. 1 is a schematic diagram of a magnetic current sensor provided in an embodiment of the present application;
FIG. 2 is a schematic cross-sectional view of a magnetic current sensor provided in an embodiment of the present application;
FIG. 3 is a cross-sectional view of the structure of a first type of differential magnetic field generation module provided in the embodiment of the present application;
FIG. 4 is a simulation diagram of a magnetic flux path of a first type of magnetic field conversion unit provided in the embodiment of the present application;
FIG. 5 is a schematic diagram of a magnetic current sensor with a magnetic field conversion unit located on the XZ plane provided in an embodiment of the present application;
FIG. 6 is a cross-sectional view of the structure of a second type of differential magnetic field generation module provided in the embodiment of the present application;
FIG. 7 is a simulation diagram of a magnetic flux path of a second type of magnetic field conversion unit provided in the embodiment of the present application;
FIG. 8 is a cross-sectional view of the structure of a third type of differential magnetic field generation module provided in the embodiment of the present application;
FIG. 9 is a simulation diagram of a magnetic flux path of a third type of magnetic field conversion unit provided in the embodiment of the present application;
FIG. 10 is a schematic diagram of a magnetic current sensor of a multi-magnetic ring structure provided in an embodiment of the present application;
FIG. 11 is a cross-sectional view of the structure of a fourth type of differential magnetic field generation module provided in the embodiment of the present application;
FIG. 12 is a simulation diagram of a magnetic flux path of a fourth type of magnetic field conversion unit applied with a Z-axis direction magnetic field provided in the embodiment of the present application;
FIG. 13 is a simulation diagram of a magnetic flux path of a fourth type of magnetic field conversion unit applied with a Y-axis direction magnetic field provided in the embodiment of the present application;
FIG. 14 is a cross-sectional view of the structure of a fifth type of differential magnetic field generation module provided in the embodiment of the present application;
FIG. 15 is a simulation diagram of a magnetic flux path of a fifth type of magnetic field conversion unit applied with a Z-axis direction magnetic field provided in the embodiment of the present application;
FIG. 16 is a simulation diagram of a magnetic flux path of a fifth type of magnetic field conversion unit applied with a Y-axis direction magnetic field provided in the embodiment of the present application;
FIG. 17 is a schematic view of the structure of a soft magnetic metal material structure of a differential magnetic field generation module provided in the embodiment of the present application;
FIG. 18 is a schematic view of the structure of a soft magnetic metal material structure of another differential magnetic field generation module provided in the embodiment of the present application;
FIG. 19 is a schematic cross-sectional view of the position of a magnetic field feedback coil provided in an embodiment of the present application.

Logos: 01-Magnetic current sensor; 10-Wire under current measurement; 20-magnetism gathering ring; 30-Differential magnetic field generation module; 40-Differential detection module; 41-Magnetic field feedback coil.

### Detailed Description of Specific Embodiments

With reference to the accompanying drawings in the embodiments of the present application, the technical solutions in the embodiments of the present application will be described clearly and completely. Obviously, the described embodiments are only part of the embodiments of the present application, rather than all embodiments. The components of the embodiments of the present application described and illustrated in the accompanying drawings can typically be arranged and designed in a variety of different configurations. Therefore, the following detailed description of the embodiments of the present application provided in the accompanying drawings is not intended to limit the claimed scope of the present application, but merely to illustrate selected embodiments of the present application. Based on the embodiments of the present application, all other embodiments that may be derived by those skilled in the art without creative effort shall fall within the scope of protection of the present application.

It should be noted that similar labels and letters in the following figures indicate similar items. Therefore, once an item is defined in one figure, it does not need to be further defined or explained in subsequent figures. The terms "comprising," "including," or any other variations thereof are intended to cover non-exclusive inclusion, such that a process, method, article, or apparatus that comprises a list of elements includes not only those elements, but also other elements not expressly listed or elements inherent to such process, method, article, or apparatus. In the absence of further restrictions, an element defined by the phrase "comprising a..." does not exclude the presence of other identical elements in the process, method, article, or apparatus that includes said element. The terms "first" and "second" are used only to distinguish one entity or operation from another entity or operation, and do not necessarily require or imply any such actual relationship or order between these entities or operations.

The inventors of the present application noticed that currently, the most widely used current sensors are magnetic current sensors, which mainly include fluxgate current sensors, Hall current sensors, and magnetoresistive current sensors. Fluxgate current sensors use high-permeability magnetic cores, which have good linearity, high accuracy, and good temperature drift performance, but they have relatively large size, complex circuitry, and high cost; Hall current sensors have a magnetic field sensitivity direction perpendicular to the plane where the Hall elements are located, and while the technology is mature, they have low sensitivity, poor temperature drift performance, and small bandwidth. There are two main current input methods for Hall current sensors: one is to sense the magnetic field of a wire under current measurement through an annular iron core, and the other is a small chip-level current sensor with its current to be measured directly input into a U-shaped copper conduction path; and magnetoresistive current sensors mainly include anisotropic magnetoresistive (AMR), giant magnetoresistive (GMR), and tunnel magnetoresistive (TMR) current sensors. Their magnetic field sensitivity direction is parallel to the plane where a magnetoresistive device is located, and they have high sensitivity and good linearity, but the magnetic field measurement range of magnetoresistive devices is smaller than that of Hall elements. Due to the consistent magnetic field direction of the above existing annular iron core structures, it is difficult to form a differential magnetic field. Annular iron cores are usually directly combined with fluxgates or Hall elements for measurement, while for magnetoresistive devices, two sets of magnetoresistive devices with opposite sensitivity directions are usually used to form a push-pull bridge for magnetic field detection in the same direction, which can easily cause angle deviation and zero-point offset, thereby affecting the sensitivity consistency. In view of this, the embodiments of the present application provide a magnetic current sensor 01 as described below.

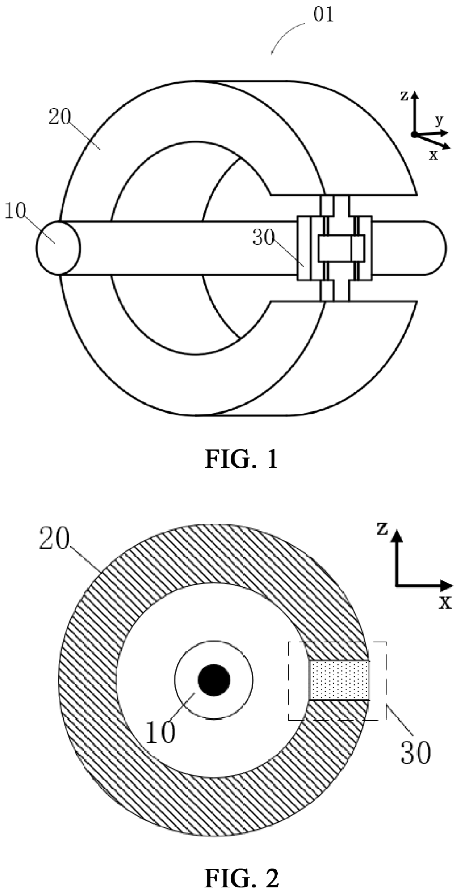

FIG. 1 is a schematic diagram of a magnetic current sensor 01 provided in an embodiment of the present application. The embodiments of the present application are explained in detail below. As shown in FIG. 1, the sensor includes: a wire under current measurement 10, a magnetism gathering ring 20, a differential magnetic field generation module 30, and a differential detection module 40; the magnetism gathering ring 20 comprises a magnetic ring structure with an opening; the wire under current measurement 10 passes through the hollow region of the magnetic ring structure; the differential magnetic field generation module 30 comprises: a magnetic field conversion unit and at least two magnetic induction units;
the differential magnetic field generation module 30 is located at the opening of the magnetic ring structure; the differential detection module 40 is electrically connected to the differential magnetic field generation module 30; the magnetic field conversion unit is connected to the open magnetic circuit to form a closed magnetic flux path; the magnetic induction unit is located at an air gap of the magnetic field conversion unit, and the sensitivity direction of the magnetic induction unit is perpendicular to the vertical projection direction of the air gap; wherein the magnetism gathering ring 20 is used to gather and amplify the induced magnetic field generated by the wire under current measurement 10; the magnetic field conversion unit is used to guide the gathered and amplified induced magnetic field to the magnetic flux path and generate a differential magnetic field component in the air gap of the magnetic flux path; the magnetic induction unit is used to generate a differential voltage signal based on the differential magnetic field component; and the differential detection module 40 is used to process the differential voltage signal and output an electrical signal to be measured.

For example, the magnetism gathering ring 20 can be a single magnetic ring structure or an integrated annular structure composed of multiple magnetic ring structures placed in parallel; for example, the magnetism gathering ring 20 shown in FIG. 2 has an annular structure parallel to the XZ plane, and the annular structure has an opening with the opening height in the Z-axis direction, the wire under current measurement 10 passes through the hollow region inside the magnetism gathering ring 20, and the magnetism gathering ring 20 gathers and amplifies the annular induced magnetic field generated by the wire under current measurement 10, which then passes through the opening along the Z-axis direction. The differential magnetic field generation module 30 can sense a current to be measured to generate an induced magnetic field, and generate a corresponding differential voltage signal by sensing the magnetic field of the current to be measured through at least one magnetic flux path structure of differential full bridge, differential half bridge, push-pull full bridge, and push-pull half bridge. Specifically, it can include a magnetic field conversion unit and at least two magnetic induction units; wherein, the magnetic field conversion unit can be made of a soft magnetic metal material having high permeability, and the magnetic flux path of the magnetic field conversion unit is formed by the magnetic flux guiding effect of the soft magnetic metal material; the magnetic induction unit (not directly shown in FIG. 1) can be: two or more giant magnetoimpedance (GMI), fluxgate, Hall elements, anomalous Hall element (AHE), or magnetoresistive sensitive elements with vertical projections located at the air gap position of the magnetic field conversion unit; for the magnetoresistive sensitive elements, the magnetic induction unit can be composed of one or more magnetoresistive sensitive elements connected in series and parallel, and the magnetoresistive sensitive element is one of anisotropic magnetoresistance (AMR), giant magnetoresistance (GMR), tunnel magnetoresistance (TMR), perpendicular tunnel magnetoresistance (PTMR), and colossal magnetoresistance (CMR). The differential detection module 40 (not directly shown in FIG. 1) can be an open-loop signal conditioning circuit or a closed-loop signal conditioning circuit, which performs conditioning and amplification, temperature compensation, and linearity correction on the differential voltage signal to form an output electrical signal to be measured of the magnetic current sensor 01.

Optionally, as shown in FIG. 2, taking the magnetism gathering ring 20 having a single magnetic ring structure as an example, assuming that the current direction in the wire under current measurement 10 is the negative Y-axis direction (perpendicular to the paper and outward), the induced magnetic field in the magnetism gathering ring 20 is in the counterclockwise direction, that is, the direction of the induced magnetic field passing through the opening is the positive Z-axis direction. The magnetism gathering ring 20 gathers and amplifies the annular induced magnetic field generated by the wire under current measurement 10, which then passes through the opening along the Z-axis direction, and the induced magnetic field along the Z-axis at the opening of the magnetism gathering ring 20 undergoes a magnetic field direction conversion through the magnetic flux path, so that the induced magnetic field in the Z-axis direction generates a component parallel to the XY plane. When converting the magnetic field direction, the magnetic flux path of the induced magnetic field can perform magnetic permeability shift by a spatial solid angle of 0-90 degrees according to the structure of the magnetic flux path, and generate an X-axis component or a Y-axis component; at the same time, since the magnetic field conversion unit is provided with one or more air gaps, the induced magnetic field along the Z-axis direction can generate an X-axis component or a Y-axis component in the air gap after the above magnetic field direction conversion; the magnetic field conversion unit and the magnetic induction unit are disposed at the opening of the magnetism gathering ring 20 parallel to the XZ plane, the sensitivity directions of the magnetic induction units are the same and perpendicular to the air gap and along the X-axis or Y-axis, and the magnetic induction unit senses the magnetic field of the magnetic field conversion unit, generates a differential voltage signal, and forms the output electrical signal to be measured through the differential detection module 40. In particular, the magnetic field conversion unit in FIG. 1 is located in the YZ plane, the magnetic flux guiding effect of the soft magnetic metal material of the magnetic field conversion unit can generate a component of the induced magnetic field in the Z-axis direction that is parallel to the XY plane, and the specific direction of the differential magnetic field component is determined by the plane in which the magnetic field conversion unit is located. Since the magnetic field conversion unit is located in the YZ plane, it can generate opposite magnetic field components in the positive and negative Y directions at air gaps at different positions for the induced magnetic field in the Z-axis direction, and form a differential magnetic field, which can be measured using magnetic inductions unit with sensitivity directions all parallel to the Y-axis.

The magnetism gathering ring 20 gathers and amplifies an annular induced magnetic field generated by the wire under current measurement 10, and then the annular induced magnetic field penetrates through the opening of the magnetism gathering ring 20; the magnetic field conversion unit located at the opening position of the magnetism gathering ring 20 forms a magnetic flux path under the magnetic flux guiding effect of a soft magnetic metal material having high permeability, the magnetic flux path is used for converting a magnetic field direction, and a magnetic field component parallel to a plane where the magnetic induction units are located is generated at the air gap of the magnetic flux path, so that a differential voltage signal is generated and an output signal is formed by means of the differential detection module 40. Differential detection with a combination of an annular iron core structure and a single-sensitivity direction magnetic induction unit can be achieved, single-chip integrated manufacturing can be achieved, the sensitivity consistency is good, the accuracy is high, the anti-interference capability is strong, and the application range is wide.

In one embodiment, the magnetism gathering ring 20 comprises: a single magnetic ring structure with an opening; the magnetic field conversion unit comprises: a magnetic field input region, a magnetic field output region, multiple magnetic flux direction conversion regions, and multiple magnetic flux path connection regions; the multiple magnetic flux path connection regions comprise: at least two air gaps located at different positions; the at least two magnetic induction units are correspondingly disposed at the positions of the at least two air gaps;
the magnetic field input region is connected to one end of the opening; the magnetic field output region is connected to the other end of the opening; the magnetic flux direction conversion region is located in a corner region of the magnetic field conversion unit, and the magnetic flux path connection region connects two adjacent corner regions and forms a closed magnetic flux path with the magnetic field input region and the magnetic field output region.

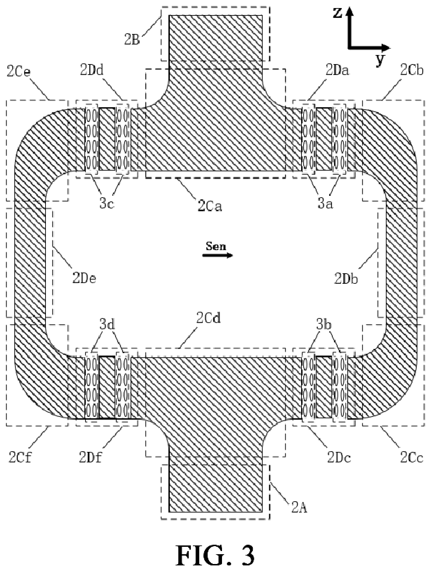

For example, in addition to a single independent magnetic field input region and a single independent magnetic field output region, i.e., the corresponding magnetic flux path has only one input port and one output port, the magnetic field conversion unit further comprises multiple magnetic flux direction conversion regions and multiple magnetic flux path connection regions. Optionally, a differential magnetic field generation module 30 structure composed of a magnetic field conversion unit and four magnetic induction units is shown in FIG. 3, where the arrow direction indicated by "sen" is the sensitivity direction of the magnetic induction unit. The magnetic field conversion unit comprises a magnetic field input region 2A, a magnetic field output region 2B, magnetic flux direction conversion regions (2Ca, 2Cb, 2Cc, 2Cd, 2Ce, 2Cf), and magnetic flux path connection regions (2Da, 2Db, 2Dc, 2Dd, 2De, 2Df). The magnetic field conversion unit can be located at the opening of the magnetism gathering ring 20 shown in FIG. 2 and is made of a soft magnetic metal material having high permeability, the magnetic field conversion unit is connected to the magnetism gathering ring 20, the soft magnetic metal material of the magnetic field conversion unit is located on the substrate embedded into the opening, so that the magnetic field output region 2B and the magnetic field input region 2A are connected to the upper and lower ends of the opening of the magnetism gathering ring 20 to form a closed magnetic circuit. Assuming the magnetic field conversion unit is located in the YZ plane, the magnetic flux direction conversion region 2Ca comprises three ports pointing to the positive Y-axis direction, the negative Y-axis direction, and the positive Z-axis direction, the magnetic flux direction conversion region 2Cb is a corner pointing to the negative Y-axis direction and the negative Z-axis direction, the magnetic flux direction conversion region 2Cc is a corner pointing to the negative Y-axis direction and the positive Z-axis direction, the magnetic flux direction conversion region 2Cd comprises three ports pointing to the positive Y-axis direction, the negative Y-axis direction, and the negative Z-axis direction, the magnetic flux direction conversion region 2Ce is a corner pointing to the positive Y-axis direction and the negative Z-axis direction, and the magnetic flux direction conversion region 2Cf is a corner pointing to the positive Y-axis direction and the positive Z-axis direction. The magnetic flux path connection region 2Da connects to the magnetic flux direction conversion regions 2Ca and 2Cb in the Y-axis direction, the magnetic flux path connection region 2Db connects to the magnetic flux direction conversion regions 2Cb and 2Cc in the Z-axis direction, the magnetic flux path connection region 2Dc connects to the magnetic flux direction conversion regions 2Cc and 2Cd in the Y-axis direction, the magnetic flux path connection region 2Dd connects to the magnetic flux direction conversion regions 2Ca and 2Ce in the Y-axis direction, the magnetic flux path connection region 2De connects to the magnetic flux direction conversion regions 2Ce and 2Cf in the Z-axis direction, and the magnetic flux path connection region 2Df connects to the magnetic flux direction conversion regions 2Cf and 2Cd in the Y-axis direction; furthermore, each of the magnetic flux path connection regions 2Da, 2Dc, 2Dd, and 2Df is provided with two air gaps that penetrate the soft magnetic metal material along the Z-axis direction.

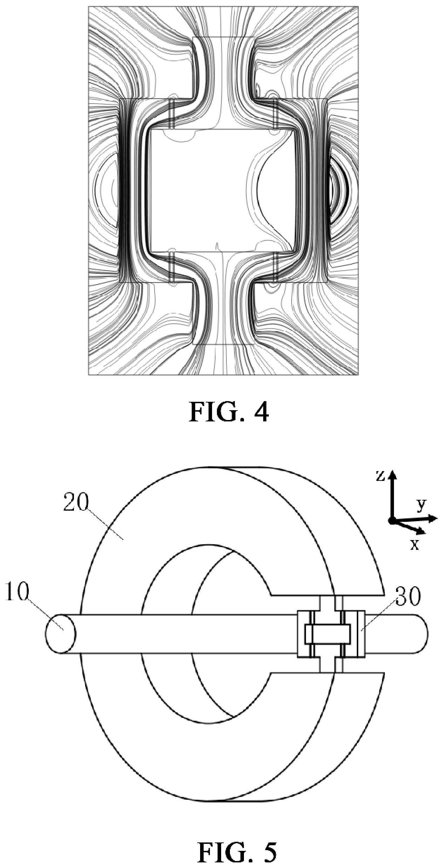

When the direction of the induced magnetic field passing through the opening is the positive Z-axis direction, the soft magnetic metal material of the magnetic field conversion unit forms a magnetic flux path through the magnetic flux guiding effect, and after the induced magnetic field enters the magnetic field input region 2A, it is twisted on two sides of the magnetic flux direction conversion region 2Cd to form two parallel magnetic flux paths in the positive and negative Y-axis directions. One of the magnetic circuits passes through the magnetic flux path connection region 2Dc with an air gap along the positive Y-axis direction, generates a magnetic field component in the positive Y-axis direction in the air gap, then passes through the magnetic flux direction conversion region 2Cc, the magnetic flux path connection region 2Db, and the magnetic flux direction conversion region 2Cb in sequence, and after being twisted from the positive Y-axis direction and reversed to the negative Y-axis direction, the magnetic circuit passes through the magnetic flux path connection region 2Da with an air gap, and generates a magnetic field component in the negative Y-axis direction in the air gap. The other magnetic circuit passes through the magnetic flux path connection region 2Df with an air gap along the negative Y-axis direction, and generates a magnetic field component in the negative Y-axis direction in the air gap; then, the magnetic circuit passes through the magnetic flux direction conversion region 2Cf, the magnetic flux path connection region 2De, and the magnetic flux direction conversion region 2Ce in sequence, and after being twisted from the negative Y-axis direction and reversed to the positive Y-axis direction, the magnetic circuit further passes through the magnetic flux path connection region 2Dd with an air gap, and generates a magnetic field component in the positive Y-axis direction in the air gap; finally, the two magnetic circuits enter the magnetic flux direction conversion region 2Ca respectively from the magnetic flux path connection region 2Da along the negative Y-axis direction and from the magnetic flux path connection region 2Dd along the positive Y-axis direction, are then twisted back to the positive Z-axis direction, and subsequently pass through the magnetic field output region 2B. As a result, the induced magnetic field in the Z-axis direction can be made to generate opposite magnetic field components in the positive and negative Y-axis directions in air gaps at different locations, thereby forming a differential magnetic field. As shown in FIG. 4, it can be seen from the simulation diagram of a magnetic flux path of the magnetic field conversion unit in FIG. 3 applied with a magnetic field in the positive Z-axis direction that the induced magnetic field along the Z-axis direction is divided into two sides, twisted, and reversed to form two parallel magnetic flux paths, and finally twisted back to the Z-axis direction. The magnetic flux path of the induced magnetic field performs magnetic permeability shift by a spatial solid angle of 0-90 degrees according to the structure of the magnetic flux direction conversion region, and generates components parallel to the XY plane at the air gaps of the magnetic flux path connection regions 2Da, 2Dc, 2Dd, and 2Df. Specifically, distinct magnetic field components in the positive Y-axis direction can be generated at the air gaps of the magnetic flux path connection regions 2Dc and 2Dd, and distinct magnetic field components in the negative Y-axis direction can be generated at the air gaps of the magnetic flux path connection regions 2Da and 2Df.

Among them, the four magnetic induction units can respectively be 3a, 3b, 3c, and 3d in FIG. 3, the sensitivity directions of all magnetic induction units are the positive Y-axis direction, and the vertical projections of the magnetic induction units 3a, 3b, 3c, and 3d are respectively located at the air gaps of the magnetic flux path connection regions 2Da, 2Dc, 2Dd, and 2Df in the magnetic field conversion unit. Taking the magnetic induction unit being tunnel magnetoresistive (TMR) as an example, since the magnetic field components at the air gaps of the magnetic flux path connection regions 2Dc and 2Dd are in the positive Y-axis direction, and the magnetic field components at the air gaps of the magnetic flux path connection regions 2Da and 2Df are in the negative Y-axis direction, the resistance values of the magnetic induction units 3b and 3c decrease, while the resistance values of the magnetic induction units 3a and 3d increase. Therefore, a push-pull full-bridge structure can be used to sense the magnetic field in the positive Z-axis direction and generate a differential voltage signal. The open-loop signal conditioning circuit is used to perform conditioning and amplification, temperature compensation, and linearity correction on the differential voltage signal, which then forms an output electrical signal to be measured of the current sensor. Furthermore, the magnetic field conversion unit located in the XZ plane as shown in FIG. 5 can be used to perform differential detection, which can make the induced magnetic field in the Z-axis direction to generate opposite magnetic field components in the positive and negative X-axis directions in air gaps at different locations and form a differential magnetic field, and a magnetic induction unit with the sensitivity direction parallel to the X-axis is used for measurement.

The annular iron core with a single magnetic ring structure is used to gather and amplify the annular induced magnetic field of the wire under current measurement 10, the magnetic flux guiding effect of the soft magnetic metal material on the substrate embedded into the opening in the magnetic field conversion unit is utilized to form two parallel magnetic flux paths, and magnetic field components with opposite directions are generated in air gaps at different locations to form a differential magnetic field, thereby enabling the formation of a push-pull bridge structure and realizing differential detection by a combination of the annular iron core structure with a single-sensitivity direction magnetic induction unit. Meanwhile, adjusting the plane where the substrate is located can be applied to magnetic induction units with sensitivity directions perpendicular to and parallel to their own planes, which avoids the problems of angle deviation and zero-point offset caused by using different sensitivity directions in the prior art, and achieves good sensitivity consistency, high measurement accuracy, and good stability.

In one embodiment, the magnetic induction unit further comprises: a magnetic shielding reference magnetic induction unit and an external magnetic field reference magnetic induction unit;

The magnetic shielding reference magnetic induction unit is located within the vertical projection range of the magnetic field conversion unit; the external magnetic field reference magnetic induction unit is located outside the vertical projection range of the magnetic field conversion unit; the at least two magnetic induction units are used to form magnetoresistance of a push-pull half-bridge or push-pull full-bridge circuit to sense the induced magnetic field to generate a differential voltage signal; or the at least two magnetic induction units are used to form magnetoresistance of a differential half-bridge or differential full-bridge circuit with the external magnetic field reference magnetic induction unit to sense the induced magnetic field to generate a differential voltage signal; or the at least one magnetic induction unit and the magnetic shielding reference magnetic induction unit are used to form magnetoresistance of a differential half-bridge or differential full-bridge circuit to sense the induced magnetic field to generate a differential voltage signal.

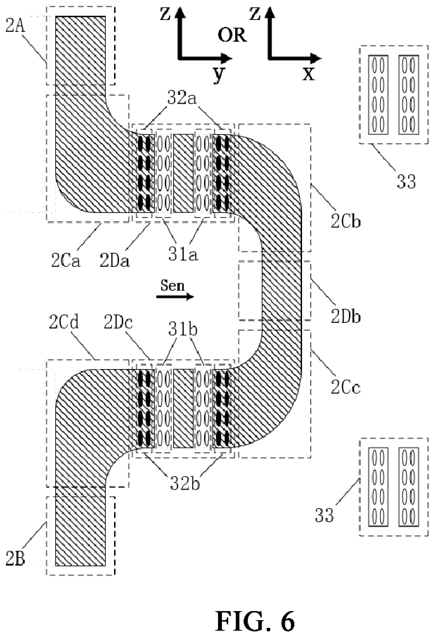

For example, as shown in FIG. 6, a differential magnetic field generation module 30 structure is composed of a magnetic field conversion unit, two magnetic induction units, two magnetic shielding reference magnetic induction units, and an external magnetic field reference magnetic induction unit, the magnetic field conversion unit comprises a magnetic field input region 2A, a magnetic field output region 2B, magnetic flux direction conversion regions (2Ca, 2Cb, 2Cc, 2Cd), and magnetic flux path connection regions (2Da, 2Db, 2Dc), and the magnetic field conversion unit can be located in the XZ plane or the YZ plane. The description is provided by taking the magnetic field conversion unit located in the YZ plane as an example. The magnetism gathering ring 20 also adopts a single magnetic ring structure, its annular structure is parallel to the YZ plane, and the opening height is along the Z-axis direction. The wire under current measurement 10 passes through the hollow region inside the magnetism gathering ring 20, and the magnetism gathering ring 20 gathers and amplifies the annular induced magnetic field generated by the wire under current measurement 10, which then passes through the opening along the Z-axis direction. Let the direction of the current in the wire under current measurement 10 be the positive Y-axis direction, then the direction of the induced magnetic field passing through the opening is the negative Z-axis direction. The magnetic flux direction conversion region 2Ca is a corner pointing to the positive Y-axis direction and the positive Z-axis direction, the magnetic flux direction conversion region 2Cb is a corner pointing to the negative Y-axis direction and the negative Z-axis direction, the magnetic flux direction conversion region 2Cc is a corner pointing to the negative Y-axis direction and the positive Z-axis direction, and the magnetic flux direction conversion region 2Cd is a corner pointing to the positive Y-axis direction and the negative Z-axis direction. The magnetic flux path connection region 2Da connects to the magnetic flux direction conversion regions 2Ca and 2Cb in the Y-axis direction, the magnetic flux path connection region 2Db connects to the magnetic flux direction conversion regions 2Cb and 2Cc in the Z-axis direction, and the magnetic flux path connection region 2Dc connects to the magnetic flux direction conversion regions 2Cc and 2Cd in the Y-axis direction; furthermore, each of the magnetic flux path connection regions 2Da and 2Dc is provided with two air gaps that penetrate the soft magnetic metal material along the Z-axis direction.

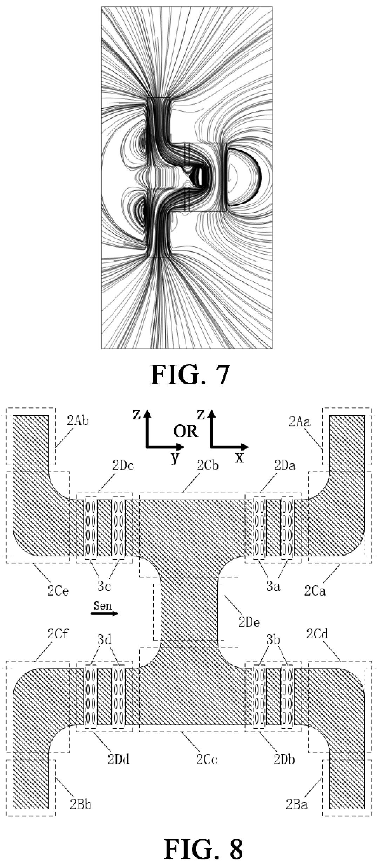

When the direction of the induced magnetic field passing through the opening is the negative Z-axis direction, the soft magnetic metal material of the magnetic field conversion unit forms a magnetic flux path through the magnetic flux guiding effect. The induced magnetic field enters the magnetic field input region 2A, passes through the magnetic flux direction conversion region 2Ca to be twisted to the positive Y-axis direction, then passes through the magnetic flux path connection region 2Da with an air gap, and generates a magnetic field component in the positive Y-axis direction in the air gap; subsequently, passes through the magnetic flux direction conversion region 2Cb, the magnetic flux path connection region 2Db, and the magnetic flux direction conversion region 2Cc in sequence, and after being twisted from the positive Y-axis direction and reversed to the negative Y-axis direction, the magnetic circuit further passes through the magnetic flux path connection region 2Dc with an air gap, and generates a magnetic field component in the negative Y-axis direction in the air gap; finally, the magnetic circuit is twisted back to the negative Z-axis direction through the magnetic flux direction conversion region 2Cd, and then passes through the magnetic field output region 2B. As a result, the induced magnetic field in the negative Z-axis direction can be made to generate opposite magnetic field components in the positive and negative Y-axis directions in air gaps at different locations, thereby forming a differential magnetic field. As shown in FIG. 7, it can be seen from the simulation diagram of a magnetic flux path of the magnetic field conversion unit in FIG. 6 applied with a magnetic field in the negative Z-axis direction that the induced magnetic field along the negative Z-axis direction is gathered and amplified by the soft magnetic metal material to form a magnetic circuit, and undergoes magnetic permeability shift by a spatial solid angle of 0-90 degrees sequentially at the magnetic flux direction conversion regions 2Ca, 2Cb, 2Cc, and 2Cd, and components parallel to the XY plane are generated at the air gaps of the magnetic flux path connection regions 2Da and 2Dc. Specifically, a distinct magnetic field component in the positive Y-axis direction can be generated at the air gap of the magnetic flux path connection region 2Da, and a distinct magnetic field component in the negative Y-axis direction can be generated at the air gap of the magnetic flux path connection region 2Dc.

Among them, two magnetic induction units, two magnetic shielding reference magnetic induction units, and one external magnetic field reference magnetic induction unit can be respectively: magnetic induction units 31a and 31b, magnetic shielding reference magnetic induction units 32a and 32b, and external magnetic field reference magnetic induction unit 33 in FIG. 6. The sensitivity directions of all magnetic induction units are the positive Y-axis direction. The vertical projection of the magnetic induction unit 31a is located at the air gap of the magnetic flux path connection region 2Da in the magnetic field conversion unit, and the vertical projection of the magnetic induction unit 31b is located at the air gap of the magnetic flux path connection region 2Dc. Therefore, the resistance value of the magnetic induction unit 31a decreases, while the resistance value of the magnetic induction unit 31b increases. The magnetic shielding reference magnetic induction units 32a and 32b are located within the vertical projection range of the soft magnetic metal material of the magnetic field conversion unit, and due to the magnetic shielding effect, the resistance value can be regarded as approximately constant. The external magnetic field reference magnetic induction unit 33 is located outside the vertical projection range of the magnetic field conversion unit, and its position is far from the soft magnetic metal material of the magnetic field conversion unit, leading to direct impact by the external magnetic field. Therefore, depending on the actual measurement requirements, for high-sensitivity detection within a small measurement range, the magnetic induction units 31a and 31b can be used to form a push-pull half-bridge structure to sense a magnetic field in the negative Z-axis direction to generate a differential voltage signa; for low-sensitivity detection within a large measurement range, the magnetic induction units 31a and 31b can be selected to form a differential half-bridge or differential full-bridge structure with the external magnetic field reference magnetic induction unit 33 to sense a magnetic field in the negative Z-axis direction to generate a differential voltage signal; alternatively, the magnetic induction units 31a and 31b can be selected to form a differential half-bridge or differential full-bridge structure with the magnetic shielding reference magnetic induction units 32a and 32b or a reference resistor with a fixed resistance value to sense a magnetic field in the negative Z-axis direction to generate a differential voltage signal. An open-loop signal conditioning circuit is used to perform conditioning and amplification, temperature compensation, and linearity correction on the differential voltage signal, which then forms an output electrical signal to be measured of the current sensor. Here, the sensitivity directions of all magnetic induction units can be the positive Y-axis direction, and when the sensitivity direction of a selected magnetic induction unit is parallel to its own plane (such as TMR, AMR, GMR, etc.), a single-chip integrated fabrication process can be used to achieve one-step single-chip fabrication.

By using a single magnetic ring structure to form an induced magnetic field, and introducing a magnetic shielding reference magnetic induction unit and an external magnetic field reference magnetic induction unit, a differential half-bridge or differential full-bridge structure is formed, which realizes the expansion of the application range and adaptive adjustments of the accuracy, reduces the process cost, and achieves good stability and high sensitivity consistency.

In one embodiment, the magnetism gathering ring 20 comprises: at least two magnetic ring structures with openings; the at least two magnetic ring structures are placed in parallel along the direction of the wire under current measurement 10; the magnetic field conversion unit comprises: at least two magnetic field input regions, at least two magnetic field output regions, multiple magnetic flux direction conversion regions, and multiple magnetic flux path connection regions; the multiple magnetic flux path connection regions comprise: at least two air gaps located at different positions; the at least two magnetic induction units are correspondingly disposed at the positions of the at least two air gaps;
the magnetic field input region is connected to one end of the opening; the magnetic field output region is connected to the other end of the opening; the magnetic flux direction conversion region is located in a corner region of the magnetic field conversion unit, and the magnetic flux path connection region connects two adjacent corner regions and forms a closed magnetic flux path with the magnetic field input region and the magnetic field output region; wherein the at least two magnetic induction units are used to form magnetoresistance of a push-pull half-bridge or push-pull full-bridge circuit to sense the induced magnetic field to generate a differential voltage signal.

For example, in addition to multiple independent magnetic field input regions and multiple independent magnetic field output regions, i.e., the corresponding magnetic flux path has multiple input ports and multiple output ports, the magnetic field conversion unit further comprises multiple magnetic flux direction conversion regions and multiple magnetic flux path connection regions. Optionally, as shown in FIG. 8, the magnetic field conversion unit comprises magnetic field input regions (2Aa, 2Ab), magnetic field output regions (2Ba, 2Bb), magnetic flux direction conversion regions (2Ca, 2Cb, 2Cc, 2Cd, 2Ce, 2Cf), and magnetic flux path connection regions (2Da, 2Db, 2Dc, 2Dd, 2De). The magnetic field conversion unit is located in the XZ plane or the YZ plane, and the description is provided by taking the magnetic field conversion unit located in the YZ plane as an example. The magnetism gathering ring 20 with two magnetic ring structures 1a, 1b placed in parallel is used to form an integrated structure with an auxiliary support housing. The annular structures 1a, 1b of the magnetism gathering ring 20 can be parallel to the YZ plane, the annular structures 1a, 1b of the magnetism gathering ring 20 has an opening, and the opening height is in the Z-axis direction; the wire under current measurement 10 passes through the hollow regions inside the annular structures 1a, 1b of the magnetism gathering ring 20, and 1a, 1b of the magnetism gathering ring 20 gather and amplify the annular induced magnetic field generated by the wire under current measurement 10, which then passes through the opening along the Z-axis direction. Let the direction of the current in the wire under current measurement 10 be the positive Y-axis direction, then the direction of the induced magnetic field passing through the opening is the negative Z-axis direction, and it is thus defined that the magnetic field input regions 2Aa and 2Ab of the magnetic field conversion unit shown in FIG. 8 are located at the end of the positive Z-axis direction of the magnetic field conversion unit, and the magnetic field output regions 2Ba and 2Bb are located at the end of the negative Z-axis direction of the magnetic field conversion unit. The magnetic field conversion unit is located at the openings of 1a, 1b of the magnetism gathering ring 20 and is made of a soft magnetic metal material having high permeability; in this embodiment, the magnetic field conversion unit is connected to 1a, 1b of the magnetism gathering ring 20, the soft magnetic metal material of the magnetic field conversion unit is located on the substrate embedded into the opening, so that the magnetic field input regions 2Aa, 2Ab and the magnetic field output region 2Ba, 2Bb are connected to the upper and lower ends of the openings of 1a, 1b of the magnetism gathering ring 20 to form a closed magnetic circuit. The magnetic flux direction conversion region 2Ca is a corner pointing to the negative Y-axis direction and the positive Z-axis direction, the magnetic flux direction conversion region 2Cb comprises three ports pointing to the positive Y-axis direction, the negative Y-axis direction, and the negative Z-axis direction, the magnetic flux direction conversion region 2Cc comprises three ports pointing to the positive Y-axis direction, the negative Y-axis direction, and the positive Z-axis direction, the magnetic flux direction conversion region 2Cd is a corner pointing to the negative Y-axis direction and the negative Z-axis direction, the magnetic flux direction conversion region 2Ce is a corner pointing to the positive Y-axis direction and the positive Z-axis direction, and the magnetic flux direction conversion region 2Cf is a corner pointing to the positive Y-axis direction and the negative Z-axis direction. The magnetic flux path connection region 2Da connects to the magnetic flux direction conversion regions 2Ca and 2Cb in the Y-axis direction, the magnetic flux path connection region 2Db connects to the magnetic flux direction conversion regions 2Cc and 2Cd in the Y-axis direction, the magnetic flux path connection region 2Dc connects to the magnetic flux direction conversion regions 2Cb and 2Ce in the Y-axis direction, the magnetic flux path connection region 2Dd connects to the magnetic flux direction conversion regions 2Cc and 2Cf in the Y-axis direction, and the magnetic flux path connection region 2De connects to the magnetic flux direction conversion regions 2Cb and 2Cc in the Z-axis direction; furthermore, each of the magnetic flux path connection regions 2Da, 2Db, 2Dc, and 2Dd is provided with two air gaps that penetrate the soft magnetic metal material along the Z-axis direction.

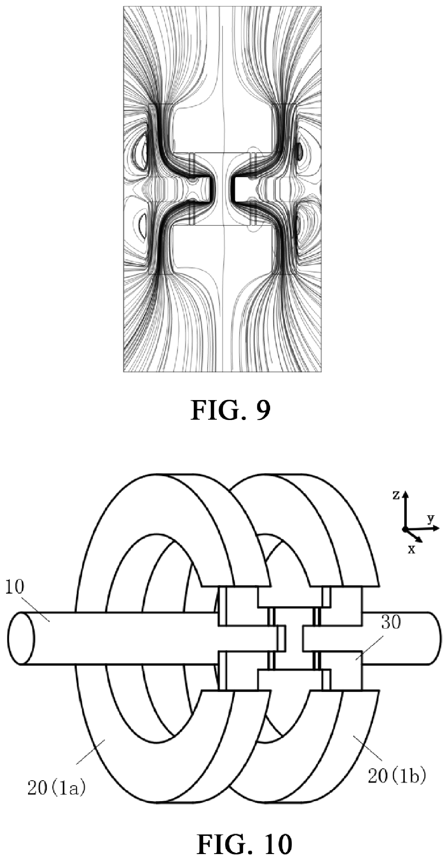

When the direction of the induced magnetic field passing through the opening is the negative Z-axis direction, the soft magnetic metal material of the magnetic field conversion unit forms a magnetic flux path through the magnetic flux guiding effect, and the induced magnetic field enters from two ends of the magnetic field input regions 2Aa and 2Ab, respectively. The magnetic circuit at the end of the magnetic field input region 2Aa is twisted to the negative Y-axis direction through the magnetic flux direction conversion region 2Ca, then passes through the magnetic flux path connection region 2Da with an air gap, and generates a magnetic field component in the negative Y-axis direction in the air gap; and the magnetic circuit at the end of the magnetic field input region 2Ab is twisted to the positive Y-axis direction through the magnetic flux direction conversion region 2Ce, then passes through the magnetic flux path connection region 2Dc with an air gap, and generates a magnetic field component in the positive Y-axis direction in the air gap. The two magnetic circuits of the magnetic flux path connection regions 2Da and 2Dc enter the magnetic flux direction conversion region 2Cb from two sides, respectively, and are twisted to the negative Z-axis direction. Then, the magnetic circuits in the negative Z-axis direction enter the magnetic flux direction conversion region 2Cc through the magnetic flux path regions 2De, and are twisted on two sides to the positive Y-axis direction and the negative Y-axis direction, respectively, to form two magnetic flux paths again. One of the magnetic circuits passes through the magnetic flux path connection region 2Db with an air gap along the positive Y-axis direction, generates a magnetic field component in the positive Y-axis direction in the air gap, then passes through the magnetic flux direction conversion region 2Cd, and after being twisted back to the negative Z-axis direction, the magnetic circuit passes through the magnetic field output region 2Ba; the other magnetic circuit passes through the magnetic flux path connection region 2Dd with an air gap along the negative Y-axis direction, generates a magnetic field component in the negative Y-axis direction in the air gap, then is twisted back to the negative Z-axis direction through the magnetic flux direction conversion region 2Cc, and subsequently passes through the magnetic field output region 2Bb. As a result, the induced magnetic field in the negative Z-axis direction can be made to generate opposite magnetic field components in the positive and negative Y-axis directions in air gaps at different locations, thereby forming a differential magnetic field. As shown in FIG. 9, it can be seen from the simulation diagram of a magnetic flux path of the magnetic field conversion unit in FIG. 8 applied with a magnetic field in the negative Z-axis direction that the induced magnetic field along the negative Z-axis direction is divided into two sides to form two symmetrical magnetic circuits, the two magnetic circuits are twisted to the positive and negative Y-axis directions respectively and then merged and twisted back to the negative Z-axis direction; subsequently, they are respectively twisted at two sides again and twisted to the positive and negative Y-axis directions to form two magnetic flux paths again, and each is twisted back to the negative Z-axis direction. The magnetic flux path of the induced magnetic field performs magnetic permeability shift by a spatial solid angle of 0-90 degrees according to the structure of the magnetic flux direction conversion region, and generates components parallel to the XY plane at the air gaps of the magnetic flux path connection regions 2Da, 2Db, 2Dc, and 2Dd. Specifically, distinct magnetic field components in the negative Y-axis direction can be generated at the air gaps of the magnetic flux path connection regions 2Da and 2Dd, and distinct magnetic field components in the positive Y-axis direction can be generated at the air gaps of the magnetic flux path connection regions 2Db and 2Dc. As shown in FIG. 10, 1a and 1b of the magnetism gathering ring 20 can be connected to the magnetic field conversion unit located in the YZ plane respectively, and the magnetic field input regions 2Aa and 2Ab and the magnetic field output regions 2Ba and 2Bb are respectively connected to the upper and lower ends of the openings of 1a and 1b of the magnetism gathering ring 20 to form a closed magnetic circuit.

Among them, the sensitivity directions of all magnetic induction units 3a, 3b, 3c, and 3d are the positive Y-axis direction, and the vertical projections of the magnetic induction units 3a, 3b, 3c, and 3d are respectively located at the air gaps of the magnetic flux path connection regions 2Da, 2Db, 2Dc, and 2Dd in the magnetic field conversion unit. Taking the magnetic induction unit being tunnel magnetoresistive (TMR) as an example, since the magnetic field components at the air gaps of the magnetic flux path connection regions 2Da and 2Dd are in the negative Y-axis direction, and the magnetic field components at the air gaps of the magnetic flux path connection regions 2Db and 2Dc are in the positive Y-axis direction, the resistance values of the magnetic induction units 3a and 3d increase, while the resistance values of the magnetic induction units 3b and 3c decrease. Therefore, a push-pull full-bridge structure can be used to sense the magnetic field in the negative Z-axis direction and generate a differential voltage signal. An open-loop signal conditioning circuit is used to perform conditioning and amplification, temperature compensation, and linearity correction on the differential voltage signal, which then forms an output signal of the current sensor.

The magnetism gathering ring 20 with two magnetic ring structures placed in parallel is used to form an integrated structure with an auxiliary support housing, which gathers and amplifies the annular induced magnetic field of the wire under current measurement 10, the magnetic flux guiding effect of the soft magnetic metal material on the substrate embedded into the opening in the magnetic field conversion unit is utilized to form two magnetic flux paths that are merged and then separated, and magnetic field components with opposite directions are generated in air gaps at different locations to form a differential magnetic field, thereby enabling the formation of a push-pull bridge structure and realizing differential detection by a combination of the annular iron core structure with a single-sensitivity direction magnetic induction unit. The placement of multiple magnetic ring structure in parallel improves the flexibility of the measurement range, and the single-sensitivity direction magnetic induction unit avoids the problems of angle deviation and zero-point offset caused by using different sensitivity directions in the prior art, and achieves good sensitivity consistency, high measurement accuracy, and good stability.

In one embodiment, the magnetic field conversion unit further comprises: a magnetic flux-shielding soft magnetic path; the magnetic flux-shielding soft magnetic path connects two magnetic flux path connection regions that are arranged opposite each other along the vertical projection direction of the air gap in the multiple magnetic flux path connection regions; and the magnetic flux-shielding soft magnetic path is used to isolate external interference magnetic fields parallel to the sensitivity direction of the magnetic induction unit.

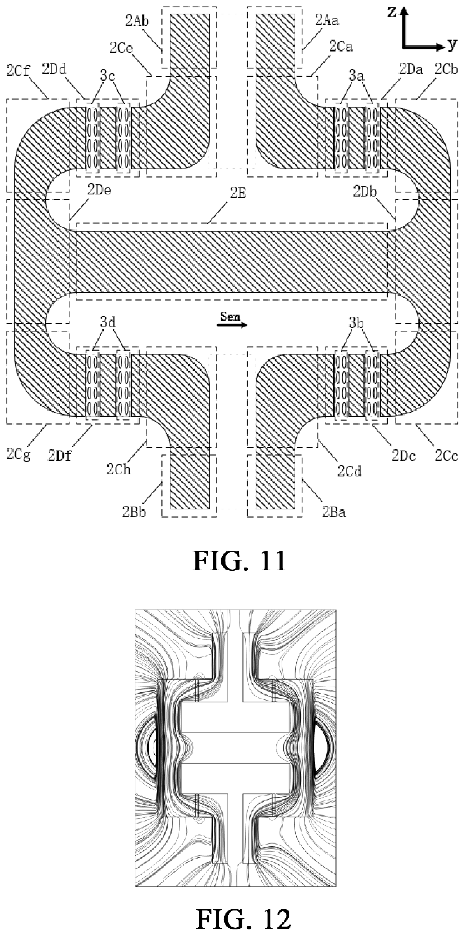

For example, as shown in FIG. 11, the magnetic field conversion unit comprises magnetic field input regions (2Aa, 2Ab), magnetic field output regions (2Ba, 2Bb), magnetic flux direction conversion regions (2Ca, 2Cb, 2Cc, 2Cd, 2Ce, 2Cf, 2Cg, 2Ch), magnetic flux path connection regions (2Da, 2Db, 2Dc, 2Dd, 2De, 2Df), and a magnetic flux-shielding soft magnetic path 2E. Compared with the magnetic field conversion unit shown in FIG. 3, the magnetic field input region 2A and the magnetic field output region 2B in FIG. 3 are symmetrically separated along the Z-axis into the magnetic field input regions 2Aa and 2Ab and the magnetic field output regions 2Ba and 2Bb; and the magnetic flux-shielding soft magnetic path 2E is introduced, to connect the magnetic flux path connection regions 2De and 2Db in FIG. 3 in the Y-axis direction. Here, the magnetic flux direction conversion regions 2Ca and 2Cg are corners pointing to the positive Y-axis direction and the positive Z-axis direction, the magnetic flux direction conversion regions 2Cb and 2Ch are corners pointing to the negative Y-axis direction and the negative Z-axis direction, the magnetic flux direction conversion regions 2Cc and 2Ce are corners pointing to the negative Y-axis direction and the positive Z-axis direction, and the magnetic flux direction conversion regions 2Cd and 2Cf are corners pointing to the positive Y-axis direction and the negative Z-axis direction. The magnetic flux path connection region 2Da connects to the magnetic flux direction conversion regions 2Ca and 2Cb in the Y-axis direction; the magnetic flux path connection region 2Db comprises three ports pointing to the negative Y-axis direction, the positive Z-axis direction, and the negative Z-axis direction, and connects to the magnetic flux direction conversion regions 2Cb and 2Cc in the Z-axis direction; the magnetic flux path connection region 2Dc connects to the magnetic flux direction conversion regions 2Cc and 2Cd in the Y-axis direction; the magnetic flux path connection region 2Dd connects to the magnetic flux direction conversion regions 2Ce and 2Cf in the Y-axis direction; the magnetic flux path connection region 2De comprises three ports pointing to the positive Y-axis direction, the positive Z-axis direction, and the negative Z-axis direction, and connects to the magnetic flux direction conversion regions 2Cf and 2Cg in the Z-axis direction; the magnetic flux path connection region 2Df connects to the magnetic flux direction conversion regions 2Cg and 2Ch in the Y-axis direction; the magnetic flux-shielding soft magnetic path 2E connects to the magnetic flux path connection regions 2De and 2Db in the Y-axis direction; furthermore, each of the magnetic flux path connection regions 2Da, 2Dc, 2Dd, and 2Df is provided with two air gaps that penetrate the soft magnetic metal material along the Z-axis direction.

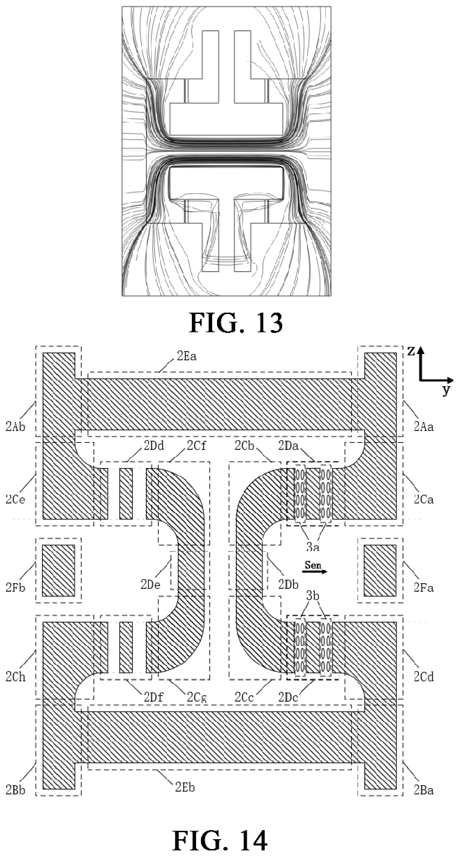

When the direction of the induced magnetic field passing through the opening is the negative Z-axis direction, the soft magnetic metal material of the magnetic field conversion unit forms a magnetic flux path through the magnetic flux guiding effect, and the induced magnetic field enters from two ends of the magnetic field input regions 2Aa and 2Ab, respectively. The magnetic circuit at the end of the magnetic field input region 2Aa is twisted to the positive Y-axis direction through the magnetic flux direction conversion region 2Ca, then passes through the magnetic flux path connection region 2Da with an air gap, and generates a magnetic field component in the positive Y-axis direction in the air gap; subsequently, passes through the magnetic flux direction conversion region 2Cb, the magnetic flux path connection region 2Db, and the magnetic flux direction conversion region 2Cc in sequence, and after being twisted from the positive Y-axis direction and reversed to the negative Y-axis direction, the magnetic circuit further passes through the magnetic flux path connection region 2Dc with an air gap, and generates a magnetic field component in the negative Y-axis direction in the air gap; finally, the magnetic circuit is twisted back to the negative Z-axis direction through the magnetic flux direction conversion region 2Cd, and then passes through the magnetic field output region 2Ba. The magnetic circuit at the end of the magnetic field input region 2Ab is twisted to the negative Y-axis direction through the magnetic flux direction conversion region 2Ce, then passes through the magnetic flux path connection region 2Dd with an air gap, and generates a magnetic field component in the negative Y-axis direction in the air gap; subsequently, passes through the magnetic flux direction conversion region 2Cf, the magnetic flux path connection region 2De, and the magnetic flux direction conversion region 2Cg in sequence, and after being twisted from the negative Y-axis direction and reversed to the positive Y-axis direction, the magnetic circuit further passes through the magnetic flux path connection region 2Df with an air gap, and generates a magnetic field component in the positive Y-axis direction in the air gap; finally, the magnetic circuit is twisted back to the negative Z-axis direction through the magnetic flux direction conversion region 2Ch, and then passes through the magnetic field output region 2Bb. As a result, the induced magnetic field in the negative Z-axis direction can be made to generate opposite magnetic field components in the positive and negative Y-axis directions in air gaps at different locations, thereby forming a differential magnetic field. As shown in FIG. 12, it can be seen from the simulation diagram of a magnetic flux path of the magnetic field conversion unit in FIG. 11 applied with a magnetic field in the negative Z-axis direction that the induced magnetic field along the negative Z-axis direction is gathered and amplified by the soft magnetic metal material, and twisted at two sides to the positive Y-axis direction and the negative Y-axis direction, respectively, to form two magnetic flux paths in parallel; and then, the two magnetic circuits are twisted to reverse in the Y-axis direction and then twisted back to the positive Z-axis direction. It can be seen that the magnetic flux path of the induced magnetic field performs magnetic permeability shift by a spatial solid angle of 0-90 degrees according to the structure of the magnetic flux direction conversion region, and generates components parallel to the XY plane at the air gaps of the magnetic flux path connection regions 2Da, 2Dc, 2Dd, and 2Df. Specifically, distinct magnetic field components in the positive Y-axis direction can be generated at the air gaps of the magnetic flux path connection regions 2Da and 2Df, and distinct magnetic field components in the negative Y-axis direction can be generated at the air gaps of the magnetic flux path connection regions 2Dc and 2Dd. Specifically, a magnetic flux-shielding soft magnetic path 2E is introduced to keep the magnetic circuit formed by the external interference magnetic field parallel to the sensitivity direction of the magnetic induction unit away from the location of the air gap, thereby restoring the measurement range. In addition, the magnetic field input region 2A and the magnetic field output region 2B are symmetrically separated along the Z-axis into magnetic field input regions 2Aa and 2Ab and magnetic field output regions 2Ba and 2Bb, which results in an isolation effect and further strengthens the shielding. As shown in FIG. 13, it can be seen from the simulation diagram of a magnetic flux path of the magnetic field conversion unit applied with a magnetic field in the Y-axis direction that the magnetic flux-shielding soft magnetic path 2E performs magnetic flux concentration in the sensitivity direction of the magnetic induction unit, and most of the external magnetic field along the Y-axis direction forms a magnetic circuit in the Y-axis direction along the magnetic flux-shielding soft magnetic path 2E, which shields the external interference magnetic field in the sensitivity direction at the air gap.

Among them, the sensitivity directions of the magnetic induction units 3a, 3b, 3c, and 3d may all be the positive Y-axis direction, and the vertical projections of the magnetic induction units 3a, 3b, 3c, and 3d are respectively located at the air gaps of the magnetic flux path connection regions 2Da, 2Dc, 2Dd, and 2Df in the magnetic field conversion unit. Thus, the resistance values of the magnetic induction units 3a and 3d decrease, while the resistance values of the magnetic induction units 3b and 3c increase. Therefore, a push-pull full-bridge structure can be used to sense a magnetic field in the negative Z-axis direction to generate a differential voltage signal. An open-loop signal conditioning circuit is used to perform conditioning and amplification, temperature compensation, and linearity correction on the differential voltage signal, which then forms an output signal of the current sensor.

By introducing a magnetic flux-shielding soft magnetic path, the magnetic field input region and the magnetic field output region are separated, which shields the external interference magnetic field in the sensitivity direction at an air gap, thereby further enhancing the measurement accuracy and measurement range and improving the anti-interference capability.

In one embodiment, the magnetic field conversion unit further comprises: a magnetic flux-dividing magnetic flux path connection region; the magnetic flux-dividing magnetic flux path connection region is located between two magnetic flux direction conversion regions that are arranged opposite each other along the vertical projection direction of the air gap in the multiple magnetic flux direction conversion regions; and the magnetic flux-dividing magnetic flux path connection region is used to perform magnetic flux dividing on the differential magnetic field generated at the air gap.

For example, as shown in FIG. 14, the magnetic field conversion unit comprises magnetic field input regions (2Aa, 2Ab), magnetic field output regions (2Ba, 2Bb), magnetic flux direction conversion regions (2Ca, 2Cb, 2Cc, 2Cd, 2Ce, 2Cf, 2Cg, 2Ch), magnetic flux path connection regions (2Da, 2Db, 2Dc, 2Dd, 2De, 2Df), magnetic flux-shielding soft magnetic paths (2Ea, 2Eb), and magnetic flux-dividing magnetic flux path connection regions (2Fa, 2Fb). Here, the magnetic flux direction conversion regions 2Ca and 2Cg are corners pointing to the negative Y-axis direction and the positive Z-axis direction, the magnetic flux direction conversion regions 2Cb and 2Ch are corners pointing to the positive Y-axis direction and the negative Z-axis direction, the magnetic flux direction conversion regions 2Cc and 2Ce are corners pointing to the positive Y-axis direction and the positive Z-axis direction, and the magnetic flux direction conversion regions 2Cd and 2Cf are corners pointing to the negative Y-axis direction and the negative Z-axis direction. The magnetic flux path connection region 2Da connects to the magnetic flux direction conversion regions 2Ca and 2Cb in the Y-axis direction, the magnetic flux path connection region 2Db connects to the magnetic flux direction conversion regions 2Cb and 2Cc in the Z-axis direction, the magnetic flux path connection region 2Dc connects to the magnetic flux direction conversion regions 2Cc and 2Cd in the Y-axis direction, the magnetic flux path connection region 2Dd connects to the magnetic flux direction conversion regions 2Ce and 2Cf in the Y-axis direction, the magnetic flux path connection region 2De connects to the magnetic flux direction conversion regions 2Cf and 2Cg in the Z-axis direction, and the magnetic flux path connection region 2Df connects to the magnetic flux direction conversion regions 2Cg and 2Ch in the Y-axis direction. The magnetic flux-shielding soft magnetic path 2Ea connects the magnetic field input regions 2Aa and 2Ab in the Y-axis direction, and the magnetic flux-shielding soft magnetic path 2Eb connects the magnetic field output regions 2Ba and 2Bb in the Y-axis direction. The magnetic flux-dividing magnetic flux path connection region 2Fa is located between the magnetic flux direction conversion regions 2Ca and 2Cd, and the magnetic flux-dividing magnetic flux path connection region 2Fb is located between the magnetic flux direction conversion regions 2Ce and 2Ch. Here, each of the magnetic flux path connection regions 2Da, 2Dc, 2Dd, and 2Df is provided with two air gaps that penetrate the soft magnetic metal material along the Z-axis direction.

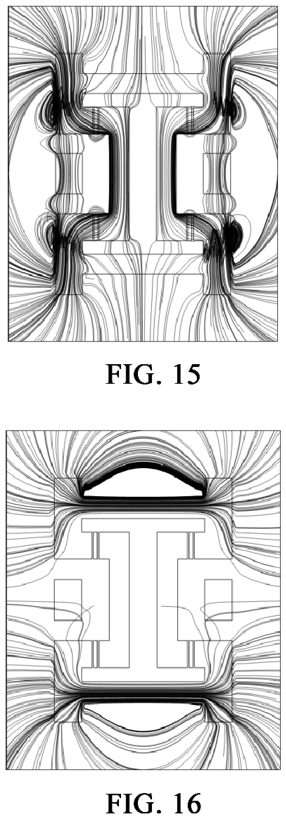

When the direction of the induced magnetic field passing through the opening is the negative Z-axis direction, the soft magnetic metal material of the magnetic field conversion unit forms a magnetic flux path through the magnetic flux guiding effect, and the induced magnetic field enters from two ends of the magnetic field input regions 2Aa and 2Ab, respectively.. For the magnetic circuit at the end of the magnetic field input region 2Aa, one part directly enters, due to the magnetic flux guiding effect of the magnetic flux-dividing magnetic flux path connection region 2Fa, the magnetic flux direction conversion region 2Cd from the magnetic flux direction conversion region 2Ca along the negative Z-axis direction, and the other part is twisted by the magnetic flux direction conversion region 2Ca to the negative Y-axis direction, passes through the magnetic flux path connection region 2Da with an air gap, and generates a magnetic field component in the negative Y-axis direction in the air gap; then, passes through the magnetic flux direction conversion region 2Cb, the magnetic flux path connection region 2Db, and the magnetic flux direction conversion region 2Cc in sequence, and after being twisted from the negative Y-axis direction and reversed to the positive Y-axis direction, the magnetic circuit further passes through the magnetic flux path connection region 2Dc with an air gap, and generates a magnetic field component in the positive Y-axis direction in the air gap; finally, the magnetic circuit is twisted back to the negative Z-axis direction through the magnetic flux direction conversion region 2Cd, and then passes through the magnetic field output region 2Ba. For the magnetic circuit at the end of the magnetic field input region 2Ab, one part directly enters, due to the magnetic flux guiding effect of the magnetic flux-dividing magnetic flux path connection region 2Fb, the magnetic flux direction conversion region 2Ch from the magnetic flux direction conversion region 2Ce along the negative Z-axis direction, and the other part is twisted by the magnetic flux direction conversion region 2Ce to the positive Y-axis direction, passes through the magnetic flux path connection region 2Dd with an air gap, and generates a magnetic field component in the positive Y-axis direction in the air gap; then, passes through the magnetic flux direction conversion region 2Cf, the magnetic flux path connection region 2De, and the magnetic flux direction conversion region 2Cg in sequence, and after being twisted from the positive Y-axis direction and reversed to the negative Y-axis direction, the magnetic circuit further passes through the magnetic flux path connection region 2Df with an air gap, and generates a magnetic field component in the negative Y-axis direction in the air gap; finally, the magnetic circuit is twisted back to the negative Z-axis direction through the magnetic flux direction conversion region 2Ch, and then passes through the magnetic field output region 2Bb. As a result, the induced magnetic field in the negative Z-axis direction can be made to generate opposite magnetic field components in the positive and negative Y-axis directions in air gaps at different locations, thereby forming a differential magnetic field. As shown in FIG. 15, it can be seen from the simulation diagram of a magnetic flux path of the magnetic field conversion unit in FIG. 14 applied with a magnetic field in the negative Z-axis direction that the induced magnetic field along the negative Z-axis direction is gathered and amplified by the soft magnetic metal material to form symmetrical magnetic circuits at two sides, and magnetic flux is divided on the magnetic circuits at both sides. The magnetic circuit at both sides each have a part that is still output directly along the negative Z-axis direction, which are twisted from both sides to the positive Y-axis direction and the negative Y-axis direction, respectively, to form two parallel magnetic flux paths, and then they are twisted and reversed in the Y-axis direction, respectively, and then twisted back to the positive Z-axis direction. It can be seen that distinct magnetic field components in the negative Y-axis direction can be generated at the air gaps of the magnetic flux path connection regions 2Da and 2Df, distinct magnetic field components in the positive Y-axis direction can be generated at the air gaps of the magnetic flux path connection regions 2Dc and 2Dd, and the magnitude of the magnetic fields at the above air gaps is weakened due to magnetic flux division. Therefore, the measurement range can be adjusted by regulating the magnitude of the magnetic field at an air gap. Specifically, the magnetic flux-shielding soft magnetic paths 2Ea and 2Eb also function to keep the magnetic circuit formed by the external interference magnetic field parallel to the sensitivity direction of the magnetic induction unit away from the location of the air gap. As shown in FIG. 16, it can be seen from the simulation diagram of a magnetic flux path of the magnetic field conversion unit applied with a magnetic field in the Y-axis direction that the magnetic flux-shielding soft magnetic paths 2Ea and 2Eb each perform magnetic flux concentration in the sensitivity direction of the magnetic induction unit, and most of the external magnetic field along the Y-axis direction forms a magnetic circuit in the Y-axis direction along the magnetic flux-shielding soft magnetic paths 2Ea and 2Eb, which shields the external interference magnetic field in the sensitivity direction at the air gap.

Among them, the sensitivity directions of the magnetic induction units 3a and 3b may both be the positive Y-axis direction, and the vertical projections of the magnetic induction units 3a and 3b are respectively located at the air gaps of the magnetic flux path connection regions 2Da and 2Dc in the magnetic field conversion unit. Thus, the resistance value of the magnetic induction unit 3a increases, while the resistance value of the magnetic induction unit 3b decreases. Therefore, a push-pull half-bridge structure can be used to sense a magnetic field in the negative Z-axis direction to generate a differential voltage signal.

By utilizing the induced magnetic field to generate magnetic field components with opposite directions in air gaps at different locations, a differential magnetic field is formed, thereby enabling the formation of a push-pull bridge structure. By introducing a magnetic flux-dividing magnetic flux path connection region, the magnitude of the magnetic field passing through an air gap can be regulated, thereby further controlling the measurement range and broadening the application scenarios.

In one embodiment, the at least two magnetic induction units of the magnetic current sensor 01 are correspondingly disposed at the at least two air gaps on the side of the direction from the magnetic field input region to the magnetic field output region.

For example, please continue to refer to FIG. 14. On the two magnetic flux paths along the direction from the magnetic field input region to the magnetic field output region, magnetic induction units 3a and 3b are disposed only at the air gap of the soft magnetic metal material on the left magnetic flux path, that is, on the side of the positive Y-axis direction. Compared with the single magnetic flux path shown in FIG. 6, which also uses only the magnetic induction units 3a and 3b to form a half-bridge structure, the magnetic field at the magnetic induction units 3a and 3b can be regarded as being weakened by approximately half by the soft magnetic metal material on the side of the negative Y-axis direction of the magnetic induction module. Therefore, it can achieve a similar effect to the magnetic flux-dividing magnetic flux path connection regions 2Fa and 2Fb in FIG. 14, and the measurement range can be adjusted by magnetic flux division. By providing at least two magnetic induction units on one side of a single magnetic flux path, a magnetic flux dividing effect can be produced to regulate the magnitude of the magnetic field at an air gap, thereby further controlling the measurement range and broadening the application scenarios.

In one embodiment, the magnetic field conversion unit and the at least two magnetic induction units are disposed on a circuit chip using a chip integration process, and the circuit chip is placed at the opening position of the magnetic ring structure.

For example, the magnetic field conversion unit and the magnetic induction unit can be located on the same circuit chip, and this chip can be placed inside the opening of the magnetism gathering ring 20. Since the sensitivity directions of all magnetic induction units are the same direction, when the sensitivity direction of a selected magnetic induction unit is parallel to its own plane (such as TMR, AMR, GMR, etc.), a single-chip integrated fabrication process can be used to achieve one-step single-chip fabrication. The magnetic field conversion unit is made of a soft magnetic metal material having high permeability, and the soft magnetic metal material is deposited on a substrate inside the circuit chip. The magnetism gathering ring 20 with one or more magnetic ring structures gathers and amplifies the induced magnetic field, the magnetic field conversion unit and the magnetic induction unit are located on the same circuit chip placed inside the opening of the magnetism gathering ring 20, the soft magnetic metal material deposited on the substrate in the magnetic field conversion unit inside the circuit chip forms, through the magnetic flux guiding effect two magnetic flux paths that are connected in parallel, and generates magnetic field components with opposite directions in air gaps at different locations to form a differential magnetic field, thereby enabling the formation of a push-pull bridge structure. The cost is reduced by using a single-chip integrated fabrication process to process the magnetic field conversion unit and the magnetic induction unit on the same chip.

In one embodiment, the magnetic flux direction conversion region and the magnetic flux path connection region of the magnetic field conversion unit share a regular rectangular structure of soft magnetic metal material.

For example, for the magnetic current sensor 01 composed of the structures shown in FIG. 3, FIG. 6, FIG. 8, FIG. 11, and FIG. 14, the magnetic field input region and magnetic field output region of the magnetic field conversion unit can be interchanged according to changes in the direction of the induced magnetic field passing through the opening. That is, for the same magnetic field conversion unit with a soft magnetic metal material structure, the magnetic field input region and the magnetic field output region are only used to indicate and describe the direction of the induced magnetic field entering and exiting the magnetic field conversion unit; when the induced magnetic field is reversed, it can be regarded as the original magnetic field input region and magnetic field output region being interchanged. In a magnetic field conversion unit, the magnetic field input region, magnetic field output region, magnetic flux direction conversion region, and magnetic flux path connection region are interconnected. In actual production, the interconnected regions actually share the same piece of soft magnetic metal material rather than independent soft magnetic metal materials. Therefore, the structure of the soft magnetic metal material in the same magnetic field conversion unit may be defined in multiple ways. Depending on the actual situation, a part of the soft magnetic metal material with an air gap can be regarded as being located in the magnetic flux path connection region or the magnetic flux direction conversion region. However, all defining ways are merely different ways of describing the structure of the present application in an illustrative manner, and do not affect the actual structures and technical features of the present application.

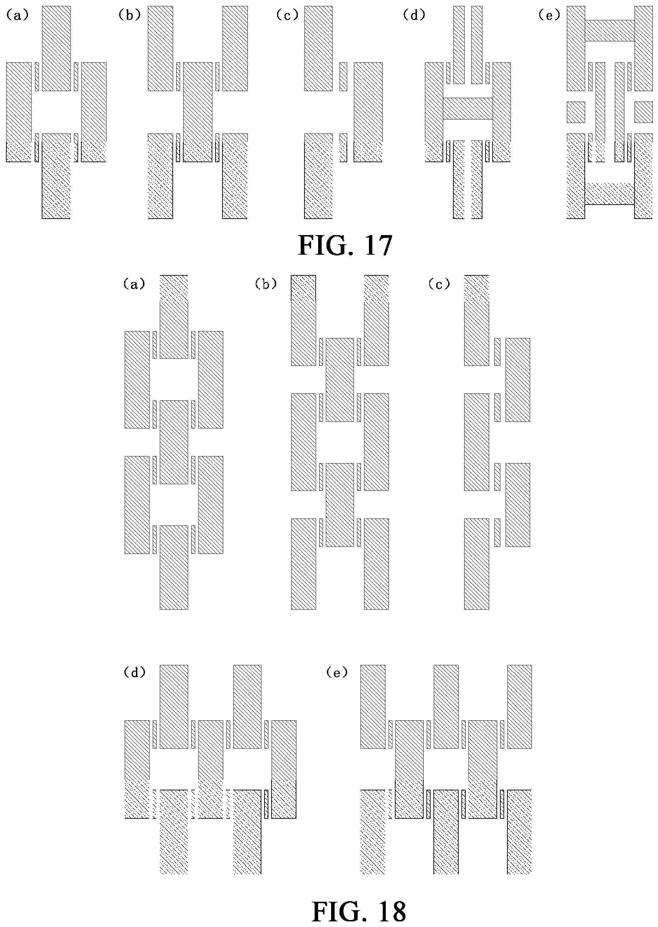

In actual production, the shape of the soft magnetic metal material of the magnetic field conversion unit can be adjusted and simplified without changing the measurement principle. At this point, the irregular soft magnetic metal material shared by the magnetic flux direction conversion region and the magnetic flux path connection region in the magnetic field conversion unit will be correspondingly simplified into a regular shape such as a rectangle. As shown in FIG. 17, the soft magnetic metal material in the magnetic field conversion unit in FIG. 3 can be replaced with the soft magnetic metal material structure shown in FIG. 17(a). The advantage of the replacement is that it reduces the difficulty and cost of the process, and in particular, it can avoid the excessively high requirements for equipment accuracy when using a single-chip integrated fabrication process. Similarly, the soft magnetic metal materials of the magnetic field conversion units in FIG. 6, FIG. 8, FIG. 11, and FIG. 14 can be replaced with the soft magnetic metal material structures shown in FIGS. 17 (c), (b), (d), and (e), respectively. In particular, the magnetic current sensor 01 composed of structures such as FIG. 3, FIG. 6, FIG. 8, FIG. 11, and FIG. 14, each magnetic circuit generated by an induced magnetic field in the magnetic field conversion unit is reversed at most once in the sensitivity direction of the magnetic induction unit. For example, in FIG. 6, it is twisted and reversed from the positive Y-axis direction to the negative Y-axis direction to form a differential magnetic field. The irregular soft magnetic metal material shared by the magnetic flux direction conversion region and the magnetic flux path connection region in the magnetic field conversion unit is correspondingly simplified into a regular shape such as a rectangle, thereby reducing the process difficulty and cost.

In one embodiment, the magnetic flux direction conversion region and the magnetic flux path connection region of the magnetic field conversion unit are formed by a regular rectangular structure of soft magnetic metal material with multiple reversals.

For example, as shown in FIG. 18, the magnetic field conversion unit can adopt a structure with multiple reversals according to actual needs. For example, the structure shown in FIG. 17(a) (i.e., the structure in FIG. 3) can be repeatedly extended along the Z-axis direction to form the structure shown in FIG. 18(a). For the soft magnetic metal material of the repeated extension of the structure shown in FIG. 18(a), due to the repetition of the structural shape, the magnetic flux path generated by the internal magnetic permeability shift and magnetic circuit distortion has the same principle as the creation of the magnetic flux path of the structure shown in FIG. 17(a), and forms the same differential magnetic field in the sensitivity direction of the magnetic induction unit, which will not be elaborated here. Similarly, FIG. 18(b) and FIG. 18(c) are soft magnetic metal material structures formed by repeatedly extending along the Z-axis based on the structures shown in FIG. 17(b) and FIG. 17(c), respectively.

Similarly, FIG. 3 and FIG. 6 use only one magnetic field input region and one magnetic field output region, while FIG. 8, FIG. 11, and FIG. 14 use two magnetic field input regions and two parallel magnetic field output regions connected in parallel, thus generating one or two series-parallel magnetic circuits respectively when entering and exiting the magnetic field conversion unit. Therefore, the magnetic field conversion unit can form multiple magnetic circuits by using multiple magnetic field input regions and multiple magnetic field output regions according to actual needs. For example, the structures shown in FIG. 17(a) and FIG. 17(b) can be repeatedly extended along the X-axis or Y-axis direction to form the structures shown in FIG. 18(d) and FIG. 18(e). For the soft magnetic metal material of the repeatedly extended parts shown in FIG. 18(d) and FIG. 18(e), due to the repetition of the structural shape, the magnetic flux paths generated by the internal magnetic permeability shift and magnetic circuit distortion have the same principle as the creation of the magnetic flux paths in FIG. 18(a) and FIG. 18(b), which will not be elaborated here. By using a rectangular structure of soft magnetic metal material with multiple reversals to form a magnetic field conversion unit, various forms of series and parallel magnetic circuits can be constructed, which are suitable for magnetic sensors with various functions, thereby expanding the application range and improving practicality.

In one embodiments, the differential detection module 40 comprises: an open-loop signal conditioning circuit; the open-loop signal conditioning circuit is electrically connected to the magnetic induction unit; and the open-loop signal conditioning circuit performs conditioning and amplification, temperature compensation, and linearity correction on the differential voltage signal.

For example, the magnetic induction unit can be giant magnetoimpedance (GMI), fluxgate, Hall elements, anomalous Hall element (AHE), or magnetoresistive sensitive elements depending on the placement position and orientation; wherein the magnetoresistive sensitive element can be one or more anisotropic magnetoresistive (AMR), giant magnetoresistive (GMR), tunnel magnetoresistive (TMR), perpendicular tunnel magnetoresistive (PTMR), and colossal magnetoresistive (CMR) resistors connected in series and parallel. Specifically, when the sensitivity direction of the magnetic induction unit is perpendicular to its own plane, the substrate where the magnetic induction unit is located is perpendicular to the plane where the magnetic field conversion unit is located. For example, if the magnetic field conversion unit located in the YZ plane selects a Hall element for measurement, then the substrate where each Hall element is located is parallel to the XZ plane. Then, the current sensor is formed by the substrate, lead pads, mechanical support housing, and other basic components together with an annular iron core, wherein an open-loop signal conditioning circuit is arranged on the substrate. An open-loop signal conditioning circuit is used to perform conditioning and amplification, temperature compensation, and linearity correction on the differential voltage signal, which then forms an output signal of the current sensor. When the sensitivity direction of the magnetic induction unit is parallel to its own plane, the substrate where it is located is parallel to the plane where the magnetic field conversion unit is located. Since all magnetic induction units can form a differential bridge or push-pull bridge using only the sensitivity in the same direction, when using a magnetic induction unit with the sensitivity parallel to its own plane, such as a tunnel magnetoresistive (TMR) unit, it is possible to fabricate it in one step, and can form the magnetic current sensor 01 together with an annular iron core structure magnetism gathering ring 20, a magnetic field conversion unit, and an open-loop signal conditioning circuit. An open-loop signal conditioning circuit is used to perform conditioning and amplification, temperature compensation, and linearity correction, thereby achieving open-loop detection, improving detection accuracy, and obtaining good linearity.

In one embodiment, the differential detection module 40 comprises: a closed-loop signal conditioning circuit and a magnetic field feedback coil 41; the closed-loop signal conditioning circuit is electrically connected to the magnetic induction unit; the closed-loop signal conditioning circuit, the magnetic field feedback coil 41, and the magnetic induction unit form a closed-loop magnetic field feedback structure; the closed-loop signal conditioning circuit is used to perform conditioning and amplification on the differential voltage signal; the magnetic field feedback coil 41 is used to generate a feedback magnetic field based on the conditioned and amplified signal to achieve dynamic magnetic field balance, and the current in the magnetic field feedback coil is sampled to form the electrical signal to be measured.

For example, the differential detection module 40 as output may use a closed-loop signal conditioning circuit and a magnetic field feedback coil 41; wherein the closed-loop signal conditioning circuit, the magnetic field feedback coil 41, and the magnetic induction unit form a closed-loop magnetic field feedback structure. After being amplified by the closed-loop signal conditioning circuit, the differential voltage signal passes through the magnetic field feedback coil 41 to generate a feedback magnetic field to achieve dynamic magnetic field balance, and after the current in the magnetic field feedback coil 41 is sampled, an output signal of the current sensor can be formed (the electrical signal to be measured). A closed-loop signal conditioning circuit and a magnetic field feedback coil 41 are used to perform differential detection, thereby realizing closed-loop negative feedback, improving accuracy, and obtaining good linearity.

In one embodiment, the magnetic field feedback coil 41 is one of: located inside the magnetic induction unit, inside the circuit chip, penetrating through the magnetism gathering ring 20, or surrounding the magnetism gathering ring.

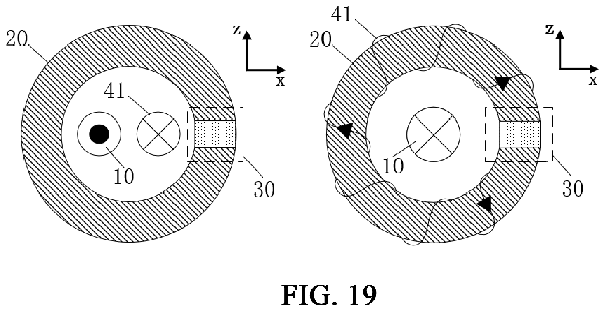

For example, the magnetic field feedback coil 41 may be located inside the magnetic induction unit or inside the circuit chip to generate a feedback current. As shown in FIG. 19, the magnetic field feedback coil 41 can also pass directly through the magnetism gathering ring 20 or surround the magnetism gathering ring 20. It can be seen that the direction of the current inside the magnetic field feedback coil 41 passing through the magnetism gathering ring 20 (the negative Y-axis direction, perpendicular to the paper and outward) is opposite to the direction of the wire under current measurement 10 (the positive Y-axis direction, perpendicular to the paper and inward). Therefore, the induced magnetic field generated therefrom is in the counterclockwise and clockwise directions. The two generate induced magnetic fields in the positive and negative Z-axis directions at the opening, respectively, thus canceling each other out to achieve dynamic magnetic field balance. The direction of the current inside the magnetic field feedback coil 41 surrounding the magnetism gathering ring 20 is shown by the arrow in FIG. 19. It directly generates a counterclockwise magnetic field in the magnetism gathering ring 20, which can cancel out the clockwise induced magnetic field generated by the wire under current measurement 10, thus achieving dynamic magnetic field balance. If a single-chip integrated fabrication process is adopted, the position of the magnetic field feedback coil 41 can be inside the magnetic induction unit or inside the circuit chip, or can also directly pass through the magnetism gathering ring 20 or surround the magnetism gathering ring 20. A closed-loop signal conditioning circuit and a magnetic field feedback coil 41 are used to perform differential detection, thereby realizing closed-loop negative feedback. The magnetic field feedback coil 41 can be located inside the magnetic induction unit, inside the circuit chip, or directly pass through the magnetism gathering ring 20, or surround the magnetism gathering ring 20, which improves the efficiency of negative feedback.

The above description is merely an embodiment of the present application and is not intended to limit the scope of protection of the present application. For those skilled in the art, the present application can have various modifications and variations. Any modifications, equivalent substitutions, and improvements made within the spirit and principles of the present application shall be encompassed within the scope of protection of the present application.

## Claims

1. A magnetic current sensor, **characterized in that** the sensor comprises:
a wire under current measurement,
a magnetism gathering ring,
a differential magnetic field generation module, and
a differential detection module;
the magnetism gathering ring comprises a magnetic ring structure with an opening; the wire under current measurement passes through the hollow region of the magnetic ring structure; the differential magnetic field generation module is located at the opening of the magnetic ring structure; the differential detection module is electrically connected to the differential magnetic field generation module;
the differential magnetic field generation module comprises: a magnetic field conversion unit and at least two magnetic induction units; the magnetic field conversion unit is connected to the open magnetic circuit to form a closed magnetic flux path;
the magnetic induction unit is located at an air gap of the magnetic field conversion unit, and the sensitivity direction of the magnetic induction unit is perpendicular to the vertical projection direction of the air gap;
wherein the magnetism gathering ring is used to gather and amplify the induced magnetic field generated by the wire under current measurement;
the magnetic field conversion unit is used to guide the gathered and amplified induced magnetic field to the magnetic flux path and generate a differential magnetic field component in the air gap of the magnetic flux path;
the magnetic induction unit is used to generate a differential voltage signal based on the differential magnetic field component; and
the differential detection module is used to process the differential voltage signal and output an electrical signal to be measured.

2. The sensor according to claim 1, **characterized in that** the magnetism gathering ring comprises: a single magnetic ring structure with an opening; the magnetic field conversion unit comprises: a magnetic field input region, a magnetic field output region, multiple magnetic flux direction conversion regions, and multiple magnetic flux path connection regions; the multiple magnetic flux path connection regions comprise: at least two air gaps located at different positions; the at least two magnetic induction units are correspondingly disposed at the positions of the at least two air gaps;
the magnetic field input region is connected to one end of the opening; the magnetic field output region is connected to the other end of the opening; the magnetic flux direction conversion region is located in a corner region of the magnetic field conversion unit, and the magnetic flux path connection region connects two adjacent corner regions and forms a closed magnetic flux path with the magnetic field input region and the magnetic field output region.

3. The sensor according to claim 2, **characterized in that** the magnetic induction unit further comprises: a magnetic shielding reference magnetic induction unit and an external magnetic field reference magnetic induction unit;
the magnetic shielding reference magnetic induction unit is located within the vertical projection range of the magnetic field conversion unit; the external magnetic field reference magnetic induction unit is located outside the vertical projection range of the magnetic field conversion unit; the at least two magnetic induction units are used to form magnetoresistance of a push-pull half-bridge or push-pull full-bridge circuit to sense the induced magnetic field to generate a differential voltage signal; or
the at least two magnetic induction units are used to form magnetoresistance of a differential half-bridge or differential full-bridge circuit with the external magnetic field reference magnetic induction unit to sense the induced magnetic field to generate a differential voltage signal; or
the at least one magnetic induction unit and the magnetic shielding reference magnetic induction unit are used to form magnetoresistance of a differential half-bridge or differential full-bridge circuit to sense the induced magnetic field to generate a differential voltage signal.

4. The sensor according to claim 1, **characterized in that** the magnetism gathering ring comprises: at least two magnetic ring structures with openings; the at least two magnetic ring structures are placed in parallel along the direction of the wire under current measurement; the magnetic field conversion unit comprises: at least two magnetic field input regions, at least two magnetic field output regions, multiple magnetic flux direction conversion regions, and multiple magnetic flux path connection regions; the multiple magnetic flux path connection regions comprise: at least two air gaps located at different positions; the at least two magnetic induction units are correspondingly disposed at the positions of the at least two air gaps;
the magnetic field input region is connected to one end of the opening; the magnetic field output region is connected to the other end of the opening; the magnetic flux direction conversion region is located in a corner region of the magnetic field conversion unit, and the magnetic flux path connection region connects two adjacent corner regions and forms a closed magnetic flux path with the magnetic field input region and the magnetic field output region;
wherein the at least two magnetic induction units are used to form magnetoresistance of a push-pull half-bridge or push-pull full-bridge circuit to sense the induced magnetic field to generate a differential voltage signal.

5. The sensor according to claim 4, **characterized in that** the magnetic field conversion unit further comprises: a magnetic flux-shielding soft magnetic path;
the magnetic flux-shielding soft magnetic path connects two magnetic flux path connection regions that are arranged opposite each other along the vertical projection direction of the air gap in the multiple magnetic flux path connection regions; and the magnetic flux-shielding soft magnetic path is used to isolate an external interference magnetic field parallel to the sensitivity direction of the magnetic induction unit.

6. The sensor according to claim 5, **characterized in that** the magnetic field conversion unit further comprises: a magnetic flux-dividing magnetic flux path connection region;
the magnetic flux-dividing magnetic flux path connection region is located between two magnetic flux direction conversion regions that are arranged opposite each other along the vertical projection direction of the air gap in the multiple magnetic flux direction conversion regions; and the magnetic flux-dividing magnetic flux path connection region is used to perform magnetic flux dividing on the differential magnetic field generated at the air gap.

7. The sensor according to claim 5, **characterized in that** the at least two magnetic induction units are correspondingly disposed at the at least two air gaps on the side of the direction from the magnetic field input region to the magnetic field output region.

8. The sensor according to any one of claims 1-7, **characterized in that** the magnetic field conversion unit and the at least two magnetic induction units are disposed on a circuit chip using a chip integration process, and the circuit chip is placed at the opening position of the magnetic ring structure.

9. The sensor according to any one of claims 2-7, **characterized in that** the magnetic flux direction conversion region and the magnetic flux path connection region share a regular rectangular structure of soft magnetic metal material.

10. The sensor according to any one of claims 2-7, **characterized in that** the magnetic flux direction conversion region and the magnetic flux path connection region are formed by a rectangular structure of soft magnetic metal material with multiple reversals.

11. The sensor according to any one of claims 1-7, **characterized in that** the differential detection module comprises: an open-loop signal conditioning circuit; the open-loop signal conditioning circuit is electrically connected to the magnetic induction unit;
and the open-loop signal conditioning circuit performs conditioning and amplification, temperature compensation, and linearity correction on the differential voltage signal.

12. The sensor according to any one of claims 1-7, **characterized in that** the differential detection module comprises: a closed-loop signal conditioning circuit and a magnetic field feedback coil; the closed-loop signal conditioning circuit is electrically connected to the magnetic induction unit; the closed-loop signal conditioning circuit, the magnetic field feedback coil, and the magnetic induction unit form a closed-loop magnetic field feedback structure;
the closed-loop signal conditioning circuit is used to perform conditioning and amplification on the differential voltage signal; the magnetic field feedback coil is used to generate a feedback magnetic field based on the conditioned and amplified signal to achieve dynamic magnetic field balance, and the current in the magnetic field feedback coil is sampled to form the electrical signal to be measured.

13. The sensor according to claim 12, **characterized in that** the magnetic field feedback coil is one of: located inside the magnetic induction unit, inside the circuit chip, penetrating through the magnetism gathering ring, or surrounding the magnetism gathering ring.
